# EUROPEAN PATENT APPLICATION

(11) **EP 4 723 395 A1**
(43) Date of publication of application: **08.04.2026**
(21) Application number: 24830543.5
(22) Date of filing: 17.06.2024
(51) Int. Cl.: H01R 13/66

(54) **POWER CONNECTOR, COMMUNICATION DEVICE, POWER DISTRIBUTION DEVICE, AND WIRELESS COMMUNICATION SYSTEM**

(30) Priority: 30.06.2023 CN 202310804522
(71) Applicant: Huawei Technologies Co., Ltd., Shenzhen, Guangdong 518129 (CN)
(72) Inventor: XIE, Zhi, Shenzhen, Guangdong 518129 (CN); SHI, Jinxian, Shenzhen, Guangdong 518129 (CN); LUO, Bin, Shenzhen, Guangdong 518129 (CN); DONG, Zhichang, Shenzhen, Guangdong 518129 (CN); XU, Hefa, Shenzhen, Guangdong 518129 (CN)
(74) Representative: Gill Jennings & Every LLP
(86) International application number: PCT/CN2024/099587
(87) International publication number: WO 2025/001897

(57) **Abstract**

This application provides a power connector, a communication device, power distribution equipment, and a wireless communication system. The power connector includes a positive power terminal, a negative power terminal, a male signal terminal, and a sampling unit. The sampling unit is configured to: detect an operating parameter of the power connector, and output the operating parameter to the male signal terminal. Further, the male signal terminal is configured to output the operating parameter to a female signal terminal, where the operating parameter is for determining whether a connection status of the power connector is an abnormal state. The connection status of the power connector includes at least one of a connection status between the positive power terminal and a positive conducting wire and a connection status between the negative power terminal and a negative conducting wire. In this application, whether the connection status of the power connector is the abnormal state is identified in advance by detecting the operating parameter of the power connector. In this way, heat-induced carbonization of the power connector can be avoided, so that reliability of the power connector is improved.

## Description

This application claims priority to Chinese Patent Application No. 202310804522.6, filed with the China National Intellectual Property Administration on June 30, 2023, and entitled "POWER CONNECTOR, COMMUNICATION DEVICE, POWER DISTRIBUTION EQUIPMENT, AND WIRELESS COMMUNICATION SYSTEM", which is incorporated herein by reference in its entirety.

### TECHNICAL FIELD

This application relates to the wireless communication field, and in particular, to a power connector, a communication device, power distribution equipment, and a wireless communication system.

### BACKGROUND

Deployment environments of base station devices are complex, and lengths of power cables for supplying power to the base station devices are different. Therefore, connections between the power cables and connectors are usually implemented through onsite cable making, to provide electric energy for the base station devices.

Currently, through a cord end terminal, screw crimping, spring clamping, strip-free insulation-piercing crimping, or the like, construction personnel connect a positive conducting wire in a power cable to a positive terminal in a connector, and connect a negative conducting wire in the power cable to a negative terminal in the connector, to implement a connection between the power cable and the connector. However, when the construction personnel do not make the cable appropriately, the power cable is in poor contact with the connector. Consequently, heat-induced carbonization of the connector is caused, or even an entire base station device is burnt out. Therefore, how to identify in advance that the power cable is in poor contact with the connector is one of problems that need to be urgently solved.

### SUMMARY

This application provides a power connector, a communication device, power distribution equipment, and a wireless communication system, so that whether a connection status of the power connector is an abnormal state can be identified in advance by detecting an operating parameter of the power connector. In this way, heat-induced carbonization of the power connector can be avoided, so that reliability of the power connector is improved.

According to a first aspect, this application provides a power connector. The power connector includes a positive power terminal, a negative power terminal, a male signal terminal, and a sampling unit, where a first end of the positive power terminal is configured to connect to a positive conducting wire in a power cable, a first end of the negative power terminal is configured to connect to a negative conducting wire in the power cable, the sampling unit is connected to a first end of the male signal terminal, and a second end of the male signal terminal is configured to connect to a female signal terminal in a device connector. The device connector may be a device connector in any current-using equipment. There may be one or more signal terminals in the male signal terminal, and there may be one or more signal terminals in the female signal terminal. In addition, the signal terminals in the male signal terminal one-to-one correspond to the signal terminals in the female signal terminal. The sampling unit is configured to: detect an operating parameter of the power connector, and output the operating parameter to the male signal terminal. Further, the male signal terminal is configured to output the operating parameter to the female signal terminal, where the operating parameter is for determining whether a connection status of the power connector is an abnormal state. The connection status of the power connector includes at least one of a connection status between the positive power terminal and the positive conducting wire and a connection status between the negative power terminal and the negative conducting wire. Through implementation of this embodiment of this application, whether the connection status of the power connector is the abnormal state is identified in advance by detecting the operating parameter of the power connector. In this way, heat-induced carbonization of the power connector can be avoided, so that reliability of the power connector is improved.

With reference to the first aspect, in a first possible implementation, the sampling unit includes a temperature detection element, the temperature detection element may be disposed between a first connection position and a second connection position, the first connection position is a connection position between the positive power terminal and the positive conducting wire, and the second connection position is a connection position between the negative power terminal and the negative conducting wire. In this case, the operating parameter is a temperature at a position of the temperature detection element, and the temperature at the position of the temperature detection element is close to a higher temperature in a temperature at the first connection position and a temperature at the second connection position. When the temperature at the position of the temperature detection element is greater than or equal to a first threshold, the connection status of the power connector is the abnormal state. That is, in this case, the power connector is in poor contact with the power cable. Through implementation of this embodiment of this application, because heat is generated when the power connector is in poor contact with the power cable, a local temperature near at least one of the first connection position and the second connection position rises. Therefore, whether the power connector is in poor contact with the power cable is identified in advance by detecting the temperature at the position of the temperature detection element. In this way, a most accurate detection feedback effect can be achieved, so that the reliability of the power connector is improved, and costs are lower.

With reference to the first aspect, in a second possible implementation, the sampling unit includes a first temperature detection element and a second temperature detection element, the first temperature detection element may be disposed on a side that is of a first connection position and that faces away from a second connection position, the second temperature detection element may be disposed on a side that is of the second connection position and that faces away from the first connection position, the first connection position is a connection position between the positive power terminal and the positive conducting wire, and the second connection position is a connection position between the negative power terminal and the negative conducting wire; and the male signal terminal includes a male positive signal terminal and a male negative signal terminal, and the female signal terminal includes a female positive signal terminal and a female negative signal terminal; and the first temperature detection element is connected to a first end of the male positive signal terminal, a second end of the male positive signal terminal is configured to connect to the female positive signal terminal, the second temperature detection element is connected to a first end of the male negative signal terminal, and a second end of the male negative signal terminal is configured to connect to the female negative signal terminal.

With reference to the second possible implementation of the first aspect, in a third possible implementation, the operating parameter includes a first temperature at a position of the first temperature detection element and a second temperature at a position of the second temperature detection element, and the connection status of the power connector includes at least one of a connection status between the positive power terminal and the positive conducting wire and a connection status between the negative power terminal and the negative conducting wire. The first temperature detection element is configured to: detect the first temperature, and output the first temperature through the male positive signal terminal, where the first temperature is close to a temperature at the first connection position. The second temperature detection element is configured to: detect the second temperature, and output the second temperature through the male negative signal terminal, where the second temperature is close to a temperature at the second connection position. When the first temperature is greater than or equal to a second threshold, the connection status between the positive power terminal and the positive conducting wire is an abnormal state. That is, in this case, the positive power terminal is in poor contact with the positive conducting wire. When the second temperature is greater than or equal to a third threshold, the connection status between the negative power terminal and the negative conducting wire is an abnormal state. That is, in this case, the negative power terminal is in poor contact with the negative conducting wire. Through implementation of this embodiment of this application, because heat is generated when the power connector is in poor contact with the power cable, a local temperature near at least one of the first connection position and the second connection position rises. Therefore, whether the positive power terminal is in poor contact with the positive conducting wire is identified in advance by detecting the first temperature, and whether the negative power terminal is in poor contact with the negative conducting wire is identified in advance by detecting the second temperature. In this way, a most accurate detection feedback effect can be achieved, and both abnormality detection on a positive pole side and abnormality detection on a negative pole side can be considered, so that the reliability of the power connector is further improved, and abnormality detection accuracy is higher.

With reference to the first aspect, in a fourth possible implementation, the sampling unit includes a first positive probe, a second positive probe, a first negative probe, and a second negative probe, the male signal terminal includes a first male positive signal terminal, a second male positive signal terminal, a first male negative signal terminal, and a second male negative signal terminal, and the female signal terminal includes a first female positive signal terminal, a second female positive signal terminal, a first female negative signal terminal, and a second female negative signal terminal; the first positive probe may be disposed between the positive conducting wire and a first end of the first male positive signal terminal, a second end of the first male positive signal terminal is configured to connect to the first female positive signal terminal, the second positive probe may be disposed between a second end of the positive power terminal and a first end of the second male positive signal terminal, and a second end of the second male positive signal terminal is configured to connect to the second female positive signal terminal; and the first negative probe may be disposed between the negative conducting wire and a first end of the first male negative signal terminal, a second end of the first male negative signal terminal is configured to connect to the first female negative signal terminal, the second negative probe may be disposed between a second end of the negative power terminal and a first end of the second male negative signal terminal, and a second end of the second male negative signal terminal is configured to connect to the second female negative signal terminal.

With reference to the fourth possible implementation of the first aspect, in a fifth possible implementation, the operating parameter includes a first positive voltage of the positive conducting wire and a second positive voltage of the positive power terminal, and the connection status of the power connector includes a connection status between the positive power terminal and the positive conducting wire. The first positive probe is configured to: detect the first positive voltage, and output the first positive voltage through the first male positive signal terminal. The second positive probe is configured to: detect the second positive voltage, and output the second positive voltage through the second male positive signal terminal. The first positive voltage and the second positive voltage are for determining a positive voltage drop at a first connection position, and the first connection position is a connection position between the positive power terminal and the positive conducting wire, where the positive voltage drop may be a voltage difference between the first positive voltage and the second positive voltage, or the positive voltage drop may be an amplified positive voltage drop obtained by amplifying a voltage difference between the first positive voltage and the second positive voltage. When the positive voltage drop is greater than or equal to a fourth threshold, the connection status between the positive power terminal and the positive conducting wire is an abnormal state. That is, in this case, the positive power terminal is in poor contact with the positive conducting wire. Through implementation of this embodiment of this application, because the positive voltage drop at the first connection position increases when the positive power terminal is in poor contact with the positive conducting wire, whether the positive power terminal is in poor contact with the positive conducting wire can be identified in advance by detecting the first positive voltage and the second positive voltage. In addition, there is no need to wait for a heat accumulation process at the first connection position, a speed of abnormality detection on a positive pole side is faster, and security is higher.

With reference to the fourth possible implementation of the first aspect or the fifth possible implementation of the first aspect, in a sixth possible implementation, the operating parameter further includes a first negative voltage of the negative conducting wire and a second negative voltage of the negative power terminal, and the connection status of the power connector further includes a connection status between the negative power terminal and the negative conducting wire. The first negative probe is configured to: detect the first negative voltage, and output the first negative voltage through the first male negative signal terminal. The second negative probe is configured to: detect the second negative voltage, and output the second negative voltage through the second male negative signal terminal. The first negative voltage and the second negative voltage are for determining a negative voltage drop at a second connection position, and the second connection position is a connection position between the negative power terminal and the negative conducting wire, where the negative voltage drop may be a voltage difference between the first negative voltage and the second negative voltage, or the negative voltage drop may be an amplified negative voltage drop obtained by amplifying a voltage difference between the first negative voltage and the second negative voltage. When the negative voltage drop is greater than or equal to a fifth threshold, the connection status between the negative power terminal and the negative conducting wire is an abnormal state. That is, in this case, the negative power terminal is in poor contact with the negative conducting wire. Through implementation of this embodiment of this application, because the negative voltage drop at the second connection position increases when the negative power terminal is in poor contact with the negative conducting wire, whether the negative power terminal is in poor contact with the negative conducting wire can be identified in advance by detecting the first negative voltage and the second negative voltage. In addition, there is no need to wait for a heat accumulation process at the second connection position, a speed of abnormality detection on a negative pole side is faster, and the security is higher.

With reference to any one of the first aspect to the fifth possible implementation of the first aspect, in a seventh possible implementation, the power connector further includes a switch, the male signal terminal includes a male switch signal terminal, and the female signal terminal includes a female switch signal terminal, where the switch may be disposed between the first end of the positive power terminal and the positive conducting wire, or the switch may be disposed between the first end of the negative power terminal and the negative conducting wire; and a control end of the switch is connected to a first end of the male switch signal terminal, and a second end of the male switch signal terminal is configured to connect to the female switch signal terminal; and after the connection status of the power connector is the abnormal state, the male switch signal terminal is configured to receive a low-level signal from the female switch signal terminal, where the low-level signal is for controlling the switch to be turned off. In this case, no current flows through the power connector. In this way, further rising of the temperature at the first connection position and the temperature at the second connection position can be avoided, so that it is ensured that further heat-induced carbonization does not occur on the power connector, and the security is higher.

According to a second aspect, this application provides a communication device. The communication device includes a device connector and a control unit, where the device connector includes a positive jack terminal, a negative jack terminal, and a female signal terminal, the positive jack terminal is configured for a positive power terminal in a power connector to be plugged into, and the negative jack terminal is configured for a negative power terminal in the power connector to be plugged into. There may be one or more signal terminals in the female signal terminal, and there may be one or more signal terminals in a male signal terminal. In addition, the signal terminals in the female signal terminal one-to-one correspond to the signal terminals in the male signal terminal. The female signal terminal is configured to: receive an operating parameter of the power connector from a male signal terminal of the power connector, and output the operating parameter to the control unit, where the operating parameter may be a temperature or a voltage, and is obtained by a sampling unit inside the power connector through detection. Further, the control unit is configured to determine, based on the operating parameter, whether a connection status of the power connector is an abnormal state. The connection status of the power connector includes at least one of a connection status between the positive power terminal and a positive conducting wire in a power cable and a connection status between the negative power terminal and a negative conducting wire in the power cable. Through implementation of this embodiment of this application, whether the connection status of the power connector is the abnormal state is identified in advance based on the operating parameter of the power connector. In this way, heat-induced carbonization of the power connector or even burnout of the communication device can be avoided, so that usage security of the communication device is improved.

With reference to the second aspect, in a first possible implementation, the operating parameter is a temperature at any position between a first connection position and a second connection position, where the temperature at the any position is close to a higher temperature in a temperature at the first connection position and a temperature at the second connection position. The first connection position is a connection position between the positive power terminal and a positive conducting wire in a power cable, and the second connection position is a connection position between the negative power terminal and a negative conducting wire in the power cable. The control unit is configured to determine whether the connection status of the power connector is the abnormal state, where the abnormal state includes that the temperature at the any position is greater than or equal to a first threshold. In this case, the power connector is in poor contact with the power cable. Through implementation of this embodiment of this application, because a local temperature near at least one of the first connection position and the second connection position rises when the power connector is in poor contact with the power cable, whether the connection status of the power connector is the abnormal state is detected based on the temperature at the any position. In this way, abnormality detection accuracy can be improved, so that the usage security of the communication device is improved.

With reference to the second aspect, in a second possible implementation, the female signal terminal includes a female positive signal terminal and a female negative signal terminal, and the male signal terminal includes a male positive signal terminal and a male negative signal terminal, where the female positive signal terminal is configured to connect to the male positive signal terminal, and the female negative signal terminal is configured to connect to the male negative signal terminal. The operating parameter includes a first temperature at any position on a side that is of a first connection position and that faces away from a second connection position, where the first temperature is close to a temperature at the first connection position. The first connection position is a connection position between the positive power terminal and a positive conducting wire in a power cable, and the second connection position is a connection position between the negative power terminal and a negative conducting wire in the power cable. The connection status of the power connector includes a connection status between the positive power terminal and the positive conducting wire. The female positive signal terminal is configured to: receive the first temperature from the male positive signal terminal, and output the first temperature to the control unit. Further, the control unit is configured to determine whether the connection status between the positive power terminal and the positive conducting wire is an abnormal state, where the abnormal state includes that the first temperature is greater than or equal to a second threshold. In this case, the positive power terminal is in poor contact with the positive conducting wire. Through implementation of this embodiment of this application, because a local temperature near the first connection position rises when the positive power terminal is in poor contact with the positive conducting wire, whether the connection status between the positive power terminal and the positive conducting wire is the abnormal state is detected based on the first temperature. In this way, accuracy of abnormality detection on a positive pole side can be improved, so that the usage security of the communication device is improved.

With reference to the second possible implementation of the second aspect, in a third possible implementation, the operating parameter further includes a second temperature at any position on a side that is of the second connection position and that faces away from the first connection position, and the connection status of the power connector further includes a connection status between the negative power terminal and the negative conducting wire. The female negative signal terminal is configured to: receive the second temperature from the male negative signal terminal, and output the second temperature to the control unit, where the second temperature is close to a temperature at the second connection position. Further, the control unit is configured to determine whether the connection status between the negative power terminal and the negative conducting wire is an abnormal state, where the abnormal state includes that the second temperature is greater than or equal to a third threshold. In this case, the negative power terminal is in poor contact with the negative conducting wire. Through implementation of this embodiment of this application, a local temperature near the second connection position rises when the negative power terminal is in poor contact with the negative conducting wire, whether the connection status between the negative power terminal and the negative conducting wire is the abnormal state is detected based on the second temperature. In this way, accuracy of abnormality detection on a negative pole side can be improved, so that the usage security of the communication device is improved. In addition, both the abnormality detection on the positive pole side and the abnormality detection on the negative pole side can be considered, and a detection manner is more flexible and comprehensive.

With reference to the second aspect, in a fourth possible implementation, the female signal terminal includes a first female positive signal terminal, a second female positive signal terminal, a first female negative signal terminal, and a second female negative signal terminal, the male signal terminal includes a first male positive signal terminal, a second male positive signal terminal, a first male negative signal terminal, and a second male negative signal terminal, and the control unit includes a differential amplifier circuit; a first end of the first female positive signal terminal is configured to connect to the first male positive signal terminal, a second end of the first female positive signal terminal is connected to a first positive input end of the differential amplifier circuit, a first end of the second female positive signal terminal is configured to connect to the second male positive signal terminal, and a second end of the second female positive signal terminal is connected to a second positive input end of the differential amplifier circuit; and a first end of the first female negative signal terminal is configured to connect to the first male negative signal terminal, a second end of the first female negative signal terminal is connected to a first negative input end of the differential amplifier circuit, a first end of the second female negative signal terminal is configured to connect to the second male negative signal terminal, and a second end of the second female negative signal terminal is connected to a second negative input end of the differential amplifier circuit.

With reference to the fourth possible implementation of the second aspect, in a fifth possible implementation, the operating parameter includes a first positive voltage of a positive conducting wire in a power cable and a second positive voltage of the positive power terminal, the connection status of the power connector includes a connection status between the positive power terminal and the positive conducting wire, and the control unit further includes a controller. The differential amplifier circuit and the controller may be disposed separately. In this case, the differential amplifier circuit may be disposed inside or outside the control unit. When the differential amplifier circuit is disposed outside the control unit, the controller is the control unit. Optionally, the differential amplifier circuit may alternatively be integrated inside the controller. A specific position of the differential amplifier circuit is not limited herein. The first female positive signal terminal is configured to: receive the first positive voltage from the first male positive signal terminal, and output the first positive voltage to the differential amplifier circuit. The second female positive signal terminal is configured to: receive the second positive voltage from the second male positive signal terminal, and output the second positive voltage to the differential amplifier circuit. Further, the differential amplifier circuit is configured to: amplify a voltage difference between the first positive voltage and the second positive voltage to obtain an amplified positive voltage drop at a first connection position, and output the amplified positive voltage drop to the controller, where the first connection position is a connection position between the positive power terminal and the positive conducting wire. The voltage difference between the first positive voltage and the second positive voltage is a positive voltage drop at the first connection position. Still further, the controller is configured to determine whether the connection status between the positive power terminal and the positive conducting wire is an abnormal state, where the abnormal state includes that the amplified positive voltage drop is greater than or equal to a fourth threshold. In this case, the positive power terminal is in poor contact with the positive conducting wire.

Through implementation of this embodiment of this application, because the positive voltage drop at the first connection position increases but by a small value when the positive power terminal is in poor contact with the positive conducting wire, the differential amplifier circuit can better detect a change process of the positive voltage drop after amplifying the positive voltage drop. In addition, there is no need to wait for a heat accumulation process at the first connection position, to quickly identify whether the connection status between the positive power terminal and the positive conducting wire is the abnormal state, so that accuracy and a speed of abnormality detection on a positive pole side can be improved, and the usage security of the communication device is improved.

With reference to the fourth possible implementation of the second aspect or the fifth possible implementation of the second aspect, in a sixth possible implementation, the control unit further includes a current detection circuit, where the current detection circuit and the controller may be separately disposed. In this case, the current detection circuit may be disposed inside or outside the control unit. Optionally, the current detection circuit may alternatively be integrated inside the controller. A specific position of the current detection circuit is not limited herein. The current detection circuit is configured to: detect a current of the positive jack terminal, and output the current of the positive jack terminal to the controller. Because a value of a current basically remains unchanged in a process in which the positive conducting wire outputs the current to the positive jack terminal through the positive power terminal, the current of the positive jack terminal is the same as a current at the first connection position. Further, the controller is configured to: obtain amplified positive impedance at the first connection position based on the amplified positive voltage drop and the current of the positive jack terminal, and determine whether the connection status between the positive power terminal and the positive conducting wire is an abnormal state, where the abnormal state includes that the amplified positive impedance is greater than or equal to a fifth threshold. In this case, the positive power terminal is in poor contact with the positive conducting wire. Through implementation of this embodiment of this application, because positive impedance at the first connection position increases but by a small value when the positive power terminal is in poor contact with the positive conducting wire, a change process of the positive impedance can be better detected after the amplified positive impedance is obtained based on the amplified positive voltage drop and the current of the positive jack terminal. In addition, there is no need to wait for the heat accumulation process at the first connection position, to quickly identify whether the connection status between the positive power terminal and the positive conducting wire is the abnormal state, so that the accuracy and the speed of the abnormality detection on the positive pole side is improved, and the usage security of the communication device is improved.

With reference to any one of the fourth possible implementation of the second aspect to the sixth possible implementation of the second aspect, in a seventh possible implementation, the operating parameter further includes a first negative voltage of a negative conducting wire in the power cable and a second negative voltage of the negative power terminal, and the connection status of the power connector further includes a connection status between the negative power terminal and the negative conducting wire. The first female negative signal terminal is configured to: receive the first negative voltage from the first male negative signal terminal, and output the first negative voltage to the differential amplifier circuit. The second female negative signal terminal is configured to: receive the second negative voltage from the second male negative signal terminal, and output the second negative voltage to the differential amplifier circuit. Further, the differential amplifier circuit is configured to: amplify a voltage difference between the first negative voltage and the second negative voltage to obtain an amplified negative voltage drop at a second connection position, and output the amplified negative voltage drop to the controller, where the second connection position is a connection position between the negative power terminal and the negative conducting wire. The voltage difference between the first negative voltage and the second negative voltage is a negative voltage drop at the second connection position. Still further, the controller is configured to determine whether the connection status between the negative power terminal and the negative conducting wire is an abnormal state, where the abnormal state includes that the amplified negative voltage drop is greater than or equal to a sixth threshold. In this case, the negative power terminal is in poor contact with the negative conducting wire.

Through implementation of this embodiment of this application, because the negative voltage drop at the second connection position increases but by a small value when the negative power terminal is in poor contact with the negative conducting wire, the differential amplifier circuit can better detect a change process of the negative voltage drop after amplifying the negative voltage drop. In addition, there is no need to wait for a heat accumulation process at the second connection position, to quickly identify whether the connection status between the negative power terminal and the negative conducting wire is the abnormal state, so that accuracy and a speed of abnormality detection on a negative pole side can be improved, and the usage security of the communication device is improved. In addition, both the abnormality detection on the positive pole side and the abnormality detection on the negative pole side can be considered, and a detection manner is more flexible and comprehensive.

Optionally, in some feasible implementations, when the controller may directly detect the change processes of the positive voltage drop and the negative voltage drop, the differential amplifier circuit may alternatively not be disposed inside the control unit. In this case, the controller may compare the positive voltage drop with a preset positive voltage drop threshold, to determine whether the connection status between the positive power terminal and the positive conducting wire is an abnormal state; and compare the negative voltage drop with a preset negative voltage drop threshold, to determine whether the connection status between the negative power terminal and the negative conducting wire is an abnormal state. The preset positive voltage drop threshold is less than the fourth threshold, and the preset negative voltage drop threshold is less than the sixth threshold.

With reference to the seventh possible implementation of the second aspect, in an eighth possible implementation, the control unit further includes the current detection circuit. The current detection circuit is configured to: detect a current of the negative jack terminal, and output the current of the negative jack terminal to the controller. Because a value of a current basically remains unchanged in a process in which the negative conducting wire outputs the current to the negative jack terminal through the negative power terminal, the current of the negative jack terminal is the same as a current at the second connection position. Further, the controller is configured to: obtain amplified negative impedance at the second connection position based on the amplified negative voltage drop and the current of the negative jack terminal, and determine whether the connection status between the negative power terminal and the negative conducting wire is an abnormal state, where the abnormal state includes that the amplified negative impedance is greater than or equal to a seventh threshold. In this case, the negative power terminal is in poor contact with the negative conducting wire. Through implementation of this embodiment of this application, because negative impedance at the second connection position increases but by a small value when the negative power terminal is in poor contact with the negative conducting wire, a change process of the negative impedance can be better detected after the amplified negative impedance is obtained based on the amplified negative voltage drop and the current of the negative jack terminal. In addition, there is no need to wait for the heat accumulation process at the second connection position, to quickly identify whether the connection status between the negative power terminal and the negative conducting wire is the abnormal state, so that the accuracy and the speed of the abnormality detection on the negative pole side can be improved, and the usage security of the communication device is improved. In addition, both the abnormality detection on the positive pole side and the abnormality detection on the negative pole side can be considered, and the detection manner is more flexible and comprehensive.

Optionally, in some feasible implementations, when the controller may directly detect the change process of the negative voltage drop, the differential amplifier circuit may alternatively not be disposed inside the control unit. In this case, the controller is configured to: obtain the positive impedance at the first connection position based on the positive voltage drop and the current of the positive jack terminal, and compare the positive impedance with a preset positive impedance threshold, to determine whether the connection status between the positive power terminal and the positive conducting wire is the abnormal state. The preset positive impedance threshold is less than the fifth threshold. The controller is further configured to: obtain the negative impedance at the second connection position based on the negative voltage drop and the current of the negative jack terminal 501, and compare the negative impedance with a preset negative impedance threshold, to determine whether the connection status between the negative power terminal and the negative conducting wire is the abnormal state. The preset negative impedance threshold is less than the seventh threshold.

With reference to the second aspect to the eighth possible implementation of the second aspect, in a ninth possible implementation, the female signal terminal includes a female switch signal terminal, and the male signal terminal includes a male switch signal terminal, where the female switch signal terminal is configured to connect to the male switch signal terminal. The control unit is configured to output a low-level signal to the female switch signal terminal after the connection status of the power connector is the abnormal state. Further, the female switch signal terminal is configured to output the low-level signal to the male switch signal terminal, where the low-level signal is for controlling a switch in the power connector to be turned off; and the switch is disposed between the positive power terminal and the positive conducting wire, or the switch is disposed between the negative power terminal and the negative conducting wire. In this case, no current flows through the power connector, so that further rising of the temperature at the first connection position and the temperature at the second connection position can be avoided, to protect the communication device from burnout.

According to a third aspect, this application provides power distribution equipment. The power distribution equipment includes a power distribution connector and a control unit, where the power distribution connector includes a positive power terminal, a negative power terminal, and a sampling unit, a first end of the positive power terminal is configured to connect to a positive conducting wire in a power cable, and a first end of the negative power terminal is configured to connect to a negative conducting wire in the power cable. The sampling unit is configured to: detect an operating parameter of the power distribution connector, and output the operating parameter to the control unit. Further, the control unit is configured to determine, based on the operating parameter, whether a connection status of the power distribution connector is an abnormal state. The connection status of the power distribution connector includes at least one of a connection status between the positive power terminal and the positive conducting wire and a connection status between the negative power terminal and the negative conducting wire. Through implementation of this embodiment of this application, whether the connection status of the power distribution connector is the abnormal state is identified in advance by detecting the operating parameter of the power distribution connector. In this way, heat-induced carbonization of the power distribution connector or even burnout of the power distribution equipment can be avoided, so that reliability of the power distribution connector is improved, and power supply security of the power distribution equipment is improved.

With reference to the third aspect, in a first possible implementation, the sampling unit includes a temperature detection element, the temperature detection element may be disposed between a first connection position and a second connection position, the first connection position is a connection position between the positive power terminal and the positive conducting wire, and the second connection position is a connection position between the negative power terminal and the negative conducting wire. The operating parameter is a temperature at a position of the temperature detection element, and the temperature at the position of the temperature detection element is close to a higher temperature in a temperature at the first connection position and a temperature at the second connection position. In this case, the control unit is configured to determine whether the connection status of the power distribution connector is the abnormal state, where the abnormal state includes that the temperature at the position of the temperature detection element is greater than or equal to a first threshold. In this case, the power distribution connector is in poor contact with the power cable. Through implementation of this embodiment of this application, because a local temperature near at least one of the first connection position and the second connection position rises when the power distribution connector is in poor contact with the power cable, whether the power distribution connector is in poor contact with the power cable is identified in advance by detecting the temperature at the position of the temperature detection element. In this way, a most accurate detection feedback effect can be achieved, and costs are lower.

With reference to the third aspect, in a second possible implementation, the sampling unit includes a first temperature detection element and a second temperature detection element, the first temperature detection element may be disposed on a side that is of a first connection position and that faces away from a second connection position, the second temperature detection element may be disposed on a side that is of the second connection position and that faces away from the first connection position, the first connection position is a connection position between the positive power terminal and the positive conducting wire, and the second connection position is a connection position between the negative power terminal and the negative conducting wire. The operating parameter includes a first temperature at a position of the first temperature detection element and a second temperature at a position of the second temperature detection element, and the connection status of the power distribution connector includes at least one of a connection status between the positive power terminal and the positive conducting wire and a connection status between the negative power terminal and the negative conducting wire. The first temperature detection element is configured to: detect the first temperature, and output the first temperature to the control unit, where the first temperature is close to a temperature at the first connection position; and the second temperature detection element is configured to: detect the second temperature, and output the second temperature to the control unit, where the second temperature is close to a temperature at the second connection position. Further, the control unit is configured to determine whether the connection status between the positive power terminal and the positive conducting wire is an abnormal state, where the abnormal state includes that the first temperature is greater than or equal to a second threshold. In this case, the positive power terminal is in poor contact with the positive conducting wire. The control unit is configured to determine whether the connection status between the negative power terminal and the negative conducting wire is an abnormal state, where the abnormal state includes that the second temperature is greater than or equal to a third threshold. In this case, the negative power terminal is in poor contact with the negative conducting wire.

Through implementation of this embodiment of this application, because a local temperature near the first connection position rises when the positive power terminal is in poor contact with the positive conducting wire, and a local temperature near the second connection position rises when the negative power terminal is in poor contact with the negative conducting wire, abnormality detection on a positive pole side and abnormality detection on a negative pole side are respectively performed based on the first temperature and the second temperature. Abnormality detection accuracy is higher, and a detection manner is more flexible and comprehensive.

With reference to the third aspect, in a third possible implementation, the sampling unit includes a first positive probe, a second positive probe, a first negative probe, and a second negative probe, and the control unit includes a differential amplifier circuit; a first end of the first positive probe is connected to the positive conducting wire, a second end of the first positive probe is connected to a first positive input end of the differential amplifier circuit, a first end of the second positive probe is connected to a second end of the positive power terminal, and a second end of the second positive probe is connected to a second positive input end of the differential amplifier circuit; and a first end of the first negative probe is connected to the negative conducting wire, a second end of the first negative probe is connected to a first negative input end of the differential amplifier circuit, a first end of the second negative probe is connected to a second end of the negative power terminal, and a second end of the second negative probe is connected to a second negative input end of the differential amplifier circuit.

With reference to the third possible implementation of the third aspect, in a fourth possible implementation, the operating parameter includes a first positive voltage of the positive conducting wire and a second positive voltage of the positive power terminal, the connection status of the power distribution connector includes a connection status between the positive power terminal and the positive conducting wire, and the control unit further includes a controller. The differential amplifier circuit and the controller may be disposed separately. In this case, the differential amplifier circuit may be disposed inside or outside the control unit. When the differential amplifier circuit is disposed outside the control unit, the controller is the control unit. Optionally, the differential amplifier circuit may alternatively be integrated inside the controller. A specific position of the differential amplifier circuit is not limited herein. The first positive probe is configured to: detect the first positive voltage, and output the first positive voltage to the differential amplifier circuit; and the second positive probe is configured to: detect the second positive voltage, and output the second positive voltage to the differential amplifier circuit. Further, the differential amplifier circuit is configured to: amplify a voltage difference between the first positive voltage and the second positive voltage to obtain an amplified positive voltage drop at a first connection position, and output the amplified positive voltage drop to the controller, where the first connection position is a connection position between the positive power terminal and the positive conducting wire. The voltage difference between the first positive voltage and the second positive voltage is a positive voltage drop at the first connection position. Still further, the controller is configured to determine whether the connection status between the positive power terminal and the positive conducting wire is an abnormal state, where the abnormal state includes that the amplified positive voltage drop is greater than or equal to a fourth threshold. In this case, the positive power terminal is in poor contact with the positive conducting wire.

Through implementation of this embodiment of this application, because the positive voltage drop at the first connection position increases but by a small value when the positive power terminal is in poor contact with the positive conducting wire, the differential amplifier circuit can better detect a change process of the positive voltage drop after amplifying the positive voltage drop. In addition, there is no need to wait for a heat accumulation process at the first connection position, to quickly identify whether the connection status between the positive power terminal and the positive conducting wire is the abnormal state, so that accuracy and a speed of abnormality detection on a positive pole side can be improved, and security is higher.

With reference to the fourth possible implementation of the third aspect, in a fifth possible implementation, the control unit further includes a current detection circuit, where the current detection circuit and the controller may be separately disposed. In this case, the current detection circuit may be disposed inside or outside the control unit. Optionally, the current detection circuit may alternatively be integrated inside the controller. A specific position of the current detection circuit is not limited herein. The current detection circuit is configured to: detect a current of the positive power terminal, and output the current of the positive power terminal to the controller, where a current of the positive power terminal is the same as a current at the first connection position. Further, the controller is configured to: obtain amplified positive impedance at the first connection position based on the amplified positive voltage drop and the current of the positive power terminal, and determine whether the connection status between the positive power terminal and the positive conducting wire is an abnormal state, where the abnormal state includes that the amplified positive impedance is greater than or equal to a fifth threshold. In this case, the positive power terminal is in poor contact with the positive conducting wire. Through implementation of this embodiment of this application, because positive impedance at the first connection position increases but by a small value when the positive power terminal is in poor contact with the positive conducting wire, a change process of the positive impedance can be better detected after the amplified positive impedance is obtained based on the amplified positive voltage drop and the current of the positive power terminal. In addition, there is no need to wait for the heat accumulation process at the first connection position, to quickly identify whether the connection status between the positive power terminal and the positive conducting wire is the abnormal state, so that the accuracy and the speed of the abnormality detection on the positive pole side is improved, and the security is higher.

With reference to any one of the third possible implementation of the third aspect to the fifth possible implementation of the third aspect, in a sixth possible implementation, the operating parameter further includes a first negative voltage of the negative conducting wire and a second negative voltage of the negative power terminal, the connection status of the power distribution connector further includes a connection status between the negative power terminal and the negative conducting wire, and the control unit further includes the controller. The first negative probe is configured to: detect the first negative voltage, and output the first negative voltage to the differential amplifier circuit; and the second negative probe is configured to: detect the second negative voltage, and output the second negative voltage to the differential amplifier circuit. Further, the differential amplifier circuit is configured to: amplify a voltage difference between the first negative voltage and the second negative voltage to obtain an amplified negative voltage drop at a second connection position, and output the amplified negative voltage drop to the controller, where the second connection position is a connection position between the negative power terminal and the negative conducting wire. The voltage difference between the first negative voltage and the second negative voltage is a negative voltage drop at the second connection position. Still further, the controller is configured to determine whether the connection status between the negative power terminal and the negative conducting wire is an abnormal state, where the abnormal state includes that the amplified negative voltage drop is greater than or equal to a sixth threshold. In this case, the negative power terminal is in poor contact with the negative conducting wire.

Through implementation of this embodiment of this application, because the negative voltage drop at the second connection position increases but by a small value when the negative power terminal is in poor contact with the negative conducting wire, the differential amplifier circuit can better detect a change process of the negative voltage drop after amplifying the negative voltage drop. In addition, there is no need to wait for a heat accumulation process at the second connection position, to quickly identify whether the connection status between the negative power terminal and the negative conducting wire is the abnormal state, so that accuracy and a speed of abnormality detection on a negative pole side can be improved, and the security is higher. In addition, both the abnormality detection on the positive pole side and the abnormality detection on the negative pole side can be considered, and a detection manner is more flexible and comprehensive.

Optionally, in some feasible implementations, when the controller may directly detect the change processes of the positive voltage drop and the negative voltage drop, the differential amplifier circuit may alternatively not be disposed inside the control unit. In this case, the controller may alternatively directly compare the positive voltage drop with a preset positive voltage drop threshold, to determine whether the connection status between the positive power terminal and the positive conducting wire is the abnormal state. The preset positive voltage drop threshold is less than the fourth threshold. The controller may alternatively directly compare the negative voltage drop with a preset negative voltage drop threshold, to determine whether the connection status between the negative power terminal and the negative conducting wire is the abnormal state. The preset negative voltage drop threshold is less than the sixth threshold.

With reference to the sixth possible implementation of the third aspect, in a seventh possible implementation, the control unit further includes the current detection circuit. The current detection circuit is configured to: detect a current of the negative power terminal, and output the current of the negative power terminal to the controller, where the current of the negative power terminal is the same as a current at the second connection position. Further, the controller is configured to: obtain amplified negative impedance at the second connection position based on the amplified negative voltage drop and the current of the negative power terminal, and determine whether the connection status between the negative power terminal and the negative conducting wire is an abnormal state, where the abnormal state includes that the amplified negative impedance is greater than or equal to a seventh threshold. In this case, the negative power terminal is in poor contact with the negative conducting wire. Through implementation of this embodiment of this application, because negative impedance at the second connection position increases but by a small value when the negative power terminal is in poor contact with the negative conducting wire, a change process of the negative impedance can be better detected after the amplified negative impedance is obtained based on the amplified negative voltage drop and the current of the negative power terminal. In addition, there is no need to wait for the heat accumulation process at the second connection position, to quickly identify whether the connection status between the negative power terminal and the negative conducting wire is the abnormal state, so that the accuracy and the speed of the abnormality detection on the negative pole side can be improved, and the security is higher. In addition, both the abnormality detection on the positive pole side and the abnormality detection on the negative pole side can be considered, and the detection manner is more flexible and comprehensive.

Optionally, in some feasible implementations, when the controller may directly detect the change process of the negative voltage drop, the differential amplifier circuit may alternatively not be disposed inside the control unit. In this case, the controller is configured to: obtain the positive impedance at the first connection position based on the positive voltage drop and the current of the positive power terminal, and compare the positive impedance with a preset positive impedance threshold, to determine whether the connection status between the positive power terminal and the positive conducting wire is the abnormal state. The preset positive impedance threshold is less than the fifth threshold. The controller is further configured to: obtain the negative impedance at the second connection position based on the negative voltage drop and the current of the negative power terminal, and compare the negative impedance with a preset negative impedance threshold, to determine whether the connection status between the negative power terminal and the negative conducting wire is the abnormal state. The preset negative impedance threshold is less than the seventh threshold.

With reference to any one of the third aspect to the seventh possible implementation of the third aspect, in an eighth possible implementation, the power distribution connector further includes a positive conductor, a negative conductor, and a switch; a third end of the positive power terminal is connected to a first end of the positive conductor, a second end of the positive conductor is configured to connect to a positive pole of an external power supply, a third end of the negative power terminal is connected to a first end of the negative conductor, and a second end of the negative conductor is configured to connect to a negative pole of the external power supply; and the switch may be disposed between the third end of the positive power terminal and the first end of the positive conductor, or the switch may be disposed between the third end of the negative power terminal and the first end of the negative conductor; and the control unit is further configured to: after the connection status of the power distribution connector is the abnormal state, control the switch to be turned off. In this case, no current flows through the power distribution connector. In this way, further rising of the temperature at the first connection position and the temperature at the second connection position can be avoided, so that the power distribution equipment is protected from burnout, and the security is higher.

According to a fourth aspect, this application provides a wireless communication system. The wireless communication system includes the power connector according to any one of the first aspect to the seventh possible implementation of the first aspect and the communication device according to any one of the second aspect to the ninth possible implementation of the second aspect. It may be understood that, the communication device may identify in advance whether a connection status of the power connector is an abnormal state, so that reliability of the power connector is improved. In this way, heat-induced carbonization of the power connector or even burnout of the communication device can be avoided, so that security of the wireless communication system is improved.

With reference to the fourth aspect, in a first possible implementation, the wireless communication system further includes the power distribution equipment according to any one of the third aspect to the eighth possible implementation of the third aspect, where the power distribution equipment is configured to supply power to the communication device through the power connector. It may be understood that, the power distribution equipment may identify in advance whether a connection status of an internal power distribution connector is an abnormal state. In this way, heat-induced carbonization of the power distribution connector or even burnout of the power distribution equipment can be avoided. In this case, abnormality detection of both the power distribution connector and the power connector can be considered, and the security of the wireless communication system is further improved.

According to a fifth aspect, this application provides a wireless communication system. The wireless communication system includes a communication device, a power connector, and the power distribution equipment according to any one of the third aspect to the eighth possible implementation of the third aspect, where the power distribution equipment is configured to supply power to the communication device through the power connector. It may be understood that, the power distribution equipment may identify in advance whether a connection status of an internal power distribution connector is an abnormal state. In this way, heat-induced carbonization of the power distribution connector or even burnout of the power distribution equipment can be avoided, so that security of the wireless communication system is improved.

For specific implementation and beneficial effects of the foregoing aspects and the possible implementations of the foregoing aspects, refer to each other.

### BRIEF DESCRIPTION OF DRAWINGS

FIG. 1 is a diagram of an application scenario of a power connector according to an embodiment of this application;
FIG. 2 is a block diagram of a structure of a power connector according to an embodiment of this application;
FIG. 3 is a diagram of a structure of a power connector according to an embodiment of this application;
FIG. 4 is a diagram of another structure of a power connector according to an embodiment of this application;
FIG. 5 is a diagram of another structure of a power connector according to an embodiment of this application;
FIG. 6 is a diagram of another structure of a power connector according to an embodiment of this application;
FIG. 7 is a block diagram of a structure of a communication device according to an embodiment of this application;
FIG. 8 is a diagram of a structure of a communication device according to an embodiment of this application;
FIG. 9 is a diagram of another structure of a communication device according to an embodiment of this application;
FIG. 10 is a diagram of another structure of a communication device according to an embodiment of this application;
FIG. 11 is a diagram of another structure of a communication device according to an embodiment of this application;
FIG. 12 is a diagram of another structure of a communication device according to an embodiment of this application;
FIG. 13 is a block diagram of a structure of power distribution equipment according to an embodiment of this application;
FIG. 14 is a diagram of a structure of power distribution equipment according to an embodiment of this application;
FIG. 15 is a diagram of another structure of power distribution equipment according to an embodiment of this application;
FIG. 16 is a diagram of another structure of power distribution equipment according to an embodiment of this application;
FIG. 17 is a diagram of another structure of power distribution equipment according to an embodiment of this application;
FIG. 18 is a block diagram of a structure of a wireless communication system according to an embodiment of this application; and
FIG. 19 is a block diagram of another structure of a wireless communication system according to an embodiment of this application.

### DESCRIPTION OF EMBODIMENTS

The following clearly and completely describes the technical solutions in embodiments of this application with reference to the accompanying drawings in embodiments of this application. It is clear that embodiments are some but not all of embodiments of this application. All other embodiments obtained by a person of ordinary skill in the art based on embodiments of this application without creative efforts shall fall within the protection scope of this application.

Implementation of the technical solutions in this application is further described below in detail with reference to the accompanying drawings.

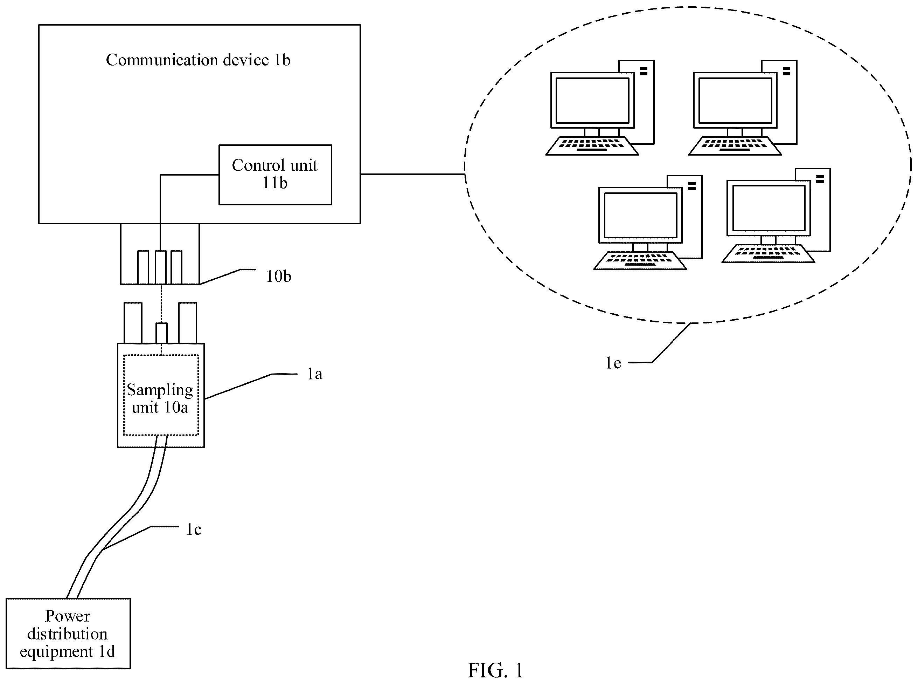

FIG. 1 is a diagram of an application scenario of a power connector according to an embodiment of this application. As shown in FIG. 1, a wireless communication system includes the power connector 1a, a communication device 1b, a power cable 1c, and power distribution equipment 1d. The power connector 1a includes a sampling unit 10a. The communication device 1b includes a device connector 10b and a control unit 11b. The power connector 1a is inserted into the device connector 10b, to supply power to the communication device 1b. When the power distribution equipment 1d performs transmission of electric energy through the power cable 1c, the power connector 1a is electrically connected to the power cable 1c, where the electric energy may be direct current electric energy or alternating current electric energy. In this case, the power connector 1a is configured to: obtain the electric energy from the power cable 1c, and output the electric energy to the device connector 10b, to implement a process of supplying the power to the communication device 1b.

In the process of supplying the power to the communication device 1b, the sampling unit 10a is configured to: detect an operating parameter of the power connector 1a in real time, and output the operating parameter to the control unit 11b through the device connector 10b. The control unit 11b is configured to determine, based on the operating parameter, whether a connection status of the power connector 1a is an abnormal state. The connection status of the power connector 1a is a connection status between the power connector 1a and the power cable 1c. Further, the control unit 11b is configured to output alarm information to a user interface of a client 1e when the connection status of the power connector 1a is the abnormal state, that is, when the power connector 1a is in poor contact with the power cable 1c. For example, the alarm information may be output to the user interface of the client 1e through optical fiber communication. The client 1e is a user end at which operations and maintenance personnel of the wireless communication system are located, and the alarm information indicates the operations and maintenance personnel to repair the power connector 1a.

Through implementation of this embodiment of this application, whether the power connector 1a is in poor contact with the power cable 1c can be identified in advance, and an alarm is output in time when it is identified that the power connector 1a is in poor contact with the power cable 1c. In this way, heat-induced carbonization of the power connector 1a or even burnout of the communication device 1b can be avoided, so that reliability of the power connector 1a is improved, and system security is higher.

The foregoing is merely an example of the application scenario of the power connector provided in this embodiment of this application, and is not exhaustive. The application scenario is not limited in this application.

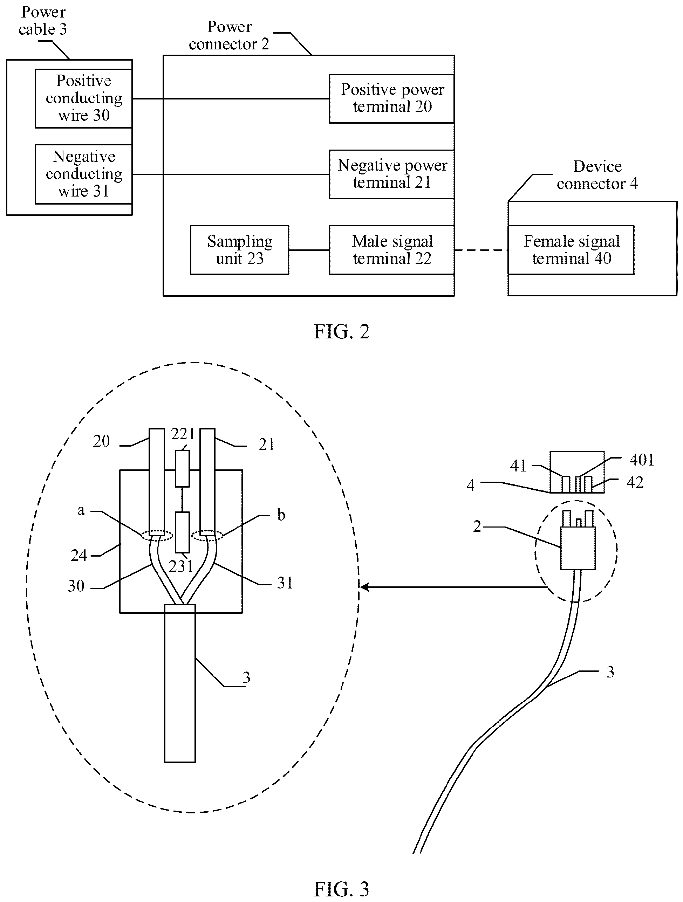

With reference to FIG. 2 to FIG. 6, the following describes, by using examples, a power connector provided in embodiments of this application and an operating principle of the power connector.

FIG. 2 is a block diagram of a structure of a power connector according to an embodiment of this application. As shown in FIG. 2, the power connector 2 includes a positive power terminal 20, a negative power terminal 21, a male signal terminal 22, and a sampling unit 23, a first end of the positive power terminal 20 is configured to connect to a positive conducting wire 30 in a power cable 3, and a first end of the negative power terminal 21 is configured to connect to a negative conducting wire 31 in the power cable 3. The sampling unit 23 is connected to a first end of the male signal terminal 22. Specifically, the sampling unit 23 is connected to the first end of the male signal terminal 22 through a signal line. A second end of the male signal terminal 22 is configured to connect to a female signal terminal 40 in a device connector 4. The device connector 4 may be a device connector in any current-using equipment. There may be one or more signal terminals in the male signal terminal 22, and there may be one or more signal terminals in the female signal terminal 40. In addition, the signal terminals in the male signal terminal 22 one-to-one correspond to the signal terminals in the female signal terminal 40.

The sampling unit 23 is configured to: detect an operating parameter of the power connector 2, and output the operating parameter to the male signal terminal 22. The operating parameter includes at least one of a parameter at a position near a first connection position between the positive power terminal 20 and the positive conducting wire 30 and a parameter at a position near a second connection position between the negative power terminal 21 and the negative conducting wire 31. Alternatively, the operating parameter includes a parameter of the positive power terminal 20, a parameter of the negative power terminal 21, a parameter of the positive conducting wire 30, and a parameter of the negative conducting wire 31.

Further, the male signal terminal 22 is configured to output the operating parameter to the female signal terminal 40, where the operating parameter is for determining whether a connection status of the power connector 2 is an abnormal state. The connection status of the power connector 2 includes at least one of a connection status between the positive power terminal 20 and the positive conducting wire 30 and a connection status between the negative power terminal 21 and the negative conducting wire 31.

Through implementation of this embodiment of this application, whether the connection status of the power connector 2 is the abnormal state is identified in advance by detecting the operating parameter of the power connector 2. In this way, heat-induced carbonization of the power connector 2 can be avoided, so that reliability of the power connector 2 is improved.

In some feasible implementations, when an external power supply supplies power to the power connector 2, an output current of the external power supply flows to the power connector 2 through the power cable 3. In this case, the positive power terminal 20 is electrically connected to the positive conducting wire 30, and the negative power terminal 21 is electrically connected to the negative conducting wire 31. When a power terminal is in poor contact with a conducting wire, heat accumulation is caused at a connection position between the power terminal and the conducting wire. Consequently, a local temperature near the connection position rises. For example, the power terminal is the positive power terminal 20, and the conducting wire is the positive conducting wire 30; and the power terminal is the negative power terminal 21, and the conducting wire is the negative conducting wire 31. Therefore, the sampling unit 23 may determine, by detecting the temperature near the connection position in real time, whether the connection status of the power connector 2 is the abnormal state.

In some feasible implementations, as shown in FIG. 3, the sampling unit 23 shown in FIG. 2 includes a temperature detection element 231. The temperature detection element 231 is disposed between a first connection position a and a second connection position b. The first connection position a is a connection position between the positive power terminal 20 and the positive conducting wire 30, and the second connection position b is a connection position between the negative power terminal 21 and the negative conducting wire 31. The male signal terminal 22 may be a male signal terminal 221 shown in FIG. 3, and the female signal terminal 40 may be a female signal terminal 401 shown in FIG. 3. The temperature detection element 231 is connected to one end of the male signal terminal 221 through a signal line, and the other end of the male signal terminal 221 is configured to connect to the female signal terminal 401. The power connector 2 further includes a connector shell 24. The temperature detection element 231 is disposed inside the connector shell 24. All terminals in the power connector 2 passes through the connector shell 24 to connect to the device connector 4.

The temperature detection element 231 is configured to: detect a temperature at a position of the temperature detection element 231, and output the temperature at the position of the temperature detection element 231 to the male signal terminal 221. In this case, the operating parameter of the power connector 2 is the temperature at the position of the temperature detection element 231. The position of the temperature detection element 231 may be any position between the first connection position a and the second connection position b. That is, in this case, the temperature at the position of the temperature detection element 231 may be a temperature at the any position. In addition, the temperature at the position of the temperature detection element 231 is close to a higher temperature in a temperature at the first connection position a and a temperature at the second connection position b.

Further, the male signal terminal 221 is configured to output the temperature at the position of the temperature detection element 231 to the female signal terminal 401. When the temperature at the position of the temperature detection element 231 is greater than or equal to a first threshold, the connection status of the power connector 2 is the abnormal state. That is, in this case, the power connector 2 is in poor contact with the power cable 3.

Through implementation of this embodiment of this application, because heat is generated when the power connector 2 is in poor contact with the power cable 3, a local temperature near at least one of the first connection position a and the second connection position b rises. Therefore, whether the power connector 2 is in poor contact with the power cable 3 is identified in advance by detecting the temperature at the position of the temperature detection element 231. In this way, a most accurate detection feedback effect can be achieved, so that the reliability of the power connector 2 is improved, and costs are lower.

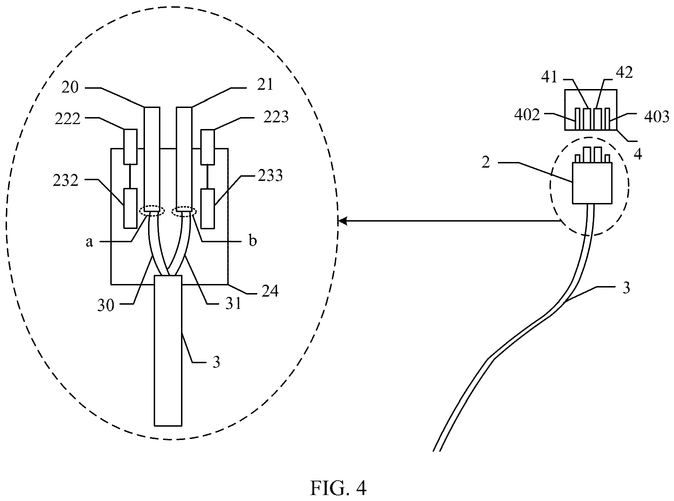

In some feasible implementations, as shown in FIG. 4, the sampling unit 23 shown in FIG. 2 includes a first temperature detection element 232 and a second temperature detection element 233. The first temperature detection element 232 may be disposed on a side that is of a first connection position a and that faces away from a second connection position b, and the second temperature detection element 233 may be disposed on a side that is of the second connection position b and that faces away from the first connection position a. The male signal terminal 22 includes a male positive signal terminal 222 and a male negative signal terminal 223, and the female signal terminal 40 includes a female positive signal terminal 402 and a female negative signal terminal 403. The first temperature detection element 232 is connected to a first end of the male positive signal terminal 222. Specifically, the first temperature detection element 232 is connected to the first end of the male positive signal terminal 222 through a signal line. A second end of the male positive signal terminal 222 is configured to connect to the female positive signal terminal 402. The second temperature detection element 233 is connected to a first end of the male negative signal terminal 223. Specifically, the second temperature detection element 233 is connected to the first end of the male negative signal terminal 223 through a signal line. A second end of the male negative signal terminal 223 is configured to connect to the female negative signal terminal 403. The power connector 2 further includes a connector shell 24. Both the first temperature detection element 232 and the second temperature detection element 233 are disposed inside the connector shell 24. All terminals in the power connector 2 pass through the connector shell 24 to connect to the device connector 4.

The first temperature detection element 232 is configured to: detect a first temperature at a position of the first temperature detection element 232, and output the first temperature through the male positive signal terminal 222. The second temperature detection element 233 is configured to: detect a second temperature at a position of the second temperature detection element 233, and output the second temperature through the male negative signal terminal 223. In this case, the operating parameter of the power connector 2 includes the first temperature and the second temperature.

The position of the first temperature detection element 232 may be any position on the side that is of the first connection position a and that faces away from the second connection position b. That is, in this case, the first temperature is a temperature at the any position on the side that is of the first connection position a and that faces away from the second connection position b. In addition, the first temperature is close to a temperature at the first connection position a. The position of the second temperature detection element 233 may be any position on the side that is of the second connection position b and that faces away from the first connection position a. That is, in this case, the second temperature is a temperature at the any position on the side that is of the second connection position b and that faces away from the first connection position a. In addition, the second temperature is close to a temperature at the second connection position b.

Further, the male positive signal terminal 222 is configured to output the first temperature to the female positive signal terminal 402. The male negative signal terminal 223 is configured to output the second temperature to the female negative signal terminal 403. In this case, the connection status of the power connector 2 includes at least one of the connection status between the positive power terminal 20 and the positive conducting wire 30 and the connection status between the negative power terminal 21 and the negative conducting wire 31. When the first temperature is greater than or equal to a second threshold, the connection status between the positive power terminal 20 and the positive conducting wire 30 is in an abnormal state. That is, in this case, the positive power terminal 20 is in poor contact with the positive conducting wire 30. When the second temperature is greater than or equal to a third threshold, the connection status between the negative power terminal 21 and the negative conducting wire 31 is the abnormal state. That is, in this case, the negative power terminal 21 is in poor contact with the negative conducting wire 31. In a possible case, the second threshold is equal to or may be unequal to the third threshold. This is not limited in this application.

Through implementation of this embodiment of this application, because heat is generated when the power connector 2 is in poor contact with the power cable 3, a local temperature near at least one of the first connection position a and the second connection position b rises. Therefore, whether the positive power terminal 20 is in poor contact with the positive conducting wire 30 is identified in advance by detecting the first temperature, and whether the negative power terminal 21 is in poor contact with the negative conducting wire 31 is identified in advance by detecting the second temperature. In this way, a most accurate detection feedback effect can be achieved, and both abnormality detection on a positive pole side and abnormality detection on a negative pole side can be considered, so that the reliability of the power connector 2 is further improved, and abnormality detection accuracy is higher.

In some feasible implementations, when a power terminal is in poor contact with a conducting wire, both a voltage drop and impedance at a connection position between the power terminal and the conducting wire increase. Therefore, the sampling unit 23 may determine, by detecting a voltage at the connection position in real time, whether the connection status of the power connector 2 is the abnormal state.

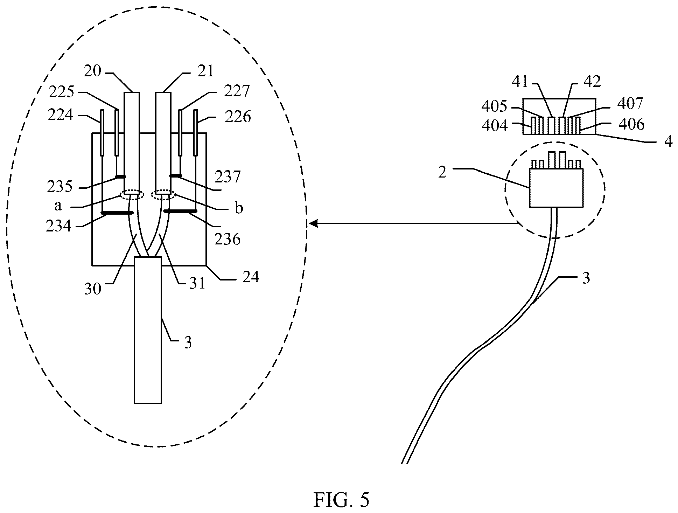

In a specific implementation, as shown in FIG. 5, the sampling unit 23 shown in FIG. 2 includes a first positive probe 234, a second positive probe 235, a first negative probe 236, and a second negative probe 237. The male signal terminal 22 includes a first male positive signal terminal 224, a second male positive signal terminal 225, a first male negative signal terminal 226, and a second male negative signal terminal 227. The female signal terminal 40 includes a first female positive signal terminal 404, a second female positive signal terminal 405, a first female negative signal terminal 406, and a second female negative signal terminal 407.

The first positive probe 234 is disposed between the positive conducting wire 30 and a first end of the first male positive signal terminal 224. Specifically, a first end of the first positive probe 234 is connected to the positive conducting wire 30, and a second end of the first positive probe 234 is connected to the first end of the first male positive signal terminal 224 through a signal line. A second end of the first male positive signal terminal 224 is configured to connect to the first female positive signal terminal 404. The second positive probe 235 is disposed between a second end of the positive power terminal 20 and a first end of the second male positive signal terminal 225. Specifically, a first end of the second positive probe 235 is connected to the second end of the positive power terminal 20, and a second end of the second positive probe 235 is connected to the first end of the second male positive signal terminal 225 through a signal line. A second end of the second male positive signal terminal 225 is configured to connect to the second female positive signal terminal 405. The second positive probe 235 and the positive power terminal 20 may be two independent components, or the second positive probe 235 may be reinforced on the positive power terminal 20 to constitute a component.

The first negative probe 236 is disposed between the negative conducting wire 31 and a first end of the first male negative signal terminal 226. Specifically, a first end of the first negative probe 236 is connected to the negative conducting wire 31, and a second end of the first negative probe 236 is connected to the first end of the first male negative signal terminal 226 through a signal line. A second end of the first male negative signal terminal 226 is configured to connect to the first female negative signal terminal 406. The second negative probe 237 is disposed between a second end of the negative power terminal 21 and a first end of the second male negative signal terminal 227. Specifically, a first end of the second negative probe 237 is connected to the second end of the negative power terminal 21, and a second end of the second negative probe 237 is connected to the first end of the second male negative signal terminal 227 through a signal line. A second end of the second male negative signal terminal 227 is configured to connect to the second female negative signal terminal 407. The second negative probe 237 and the negative power terminal 21 may be two independent components, or the second negative probe 237 may be reinforced on the negative power terminal 21 to constitute a component.

The power connector 2 further includes a connector shell 24. The first positive probe 234, the second positive probe 235, the first negative probe 236, and the second negative probe 237 are all disposed inside the connector shell 24. All terminals in the power connector 2 pass through the connector shell 24 to connect to the device connector 4.

The following describes a manner that is of abnormality detection on a positive pole side and that corresponds to FIG. 5.

The first positive probe 234 is configured to: detect a first positive voltage of the positive conducting wire 30, and output the first positive voltage through the first male positive signal terminal 224. The second positive probe 235 is configured to: detect a second positive voltage of the positive power terminal 20, and output the second positive voltage through the second male positive signal terminal 225. In this case, the operating parameter of the power connector 2 includes the first positive voltage and the second positive voltage.

Further, the first male positive signal terminal 224 is configured to output the first positive voltage to the first female positive signal terminal 404. The second male positive signal terminal 225 is configured to output the second positive voltage to the second female positive signal terminal 405. In this case, the connection status of the power connector 2 includes the connection status between the positive power terminal 20 and the positive conducting wire 30. The first positive voltage and the second positive voltage are for determining a positive voltage drop at a first connection position a. For example, the positive voltage drop may be a voltage difference between the first positive voltage and the second positive voltage, or the positive voltage drop may be an amplified positive voltage drop obtained by amplifying a voltage difference between the first positive voltage and the second positive voltage.

When the positive voltage drop is greater than or equal to a fourth threshold, the connection status between the positive power terminal 20 and the positive conducting wire 30 is an abnormal state. That is, in this case, the positive power terminal 20 is in poor contact with the positive conducting wire 30.

Through implementation of this embodiment of this application, because the positive voltage drop at the first connection position a increases when the positive power terminal 20 is in poor contact with the positive conducting wire 30, whether the positive power terminal 20 is in poor contact with the positive conducting wire 30 can be identified in advance by detecting the first positive voltage and the second positive voltage. In addition, there is no need to wait for a heat accumulation process at the first connection position a, a speed of the abnormality detection on the positive pole side is faster, and security is higher.

The following describes a manner that is of abnormality detection on a negative pole side and that corresponds to FIG. 5.

The first negative probe 236 is configured to: detect a first negative voltage of the negative conducting wire 31, and output the first negative voltage through the first male negative signal terminal 226. The second negative probe 237 is configured to: detect a second negative voltage of the negative power terminal 21, and output the second negative voltage through the second male negative signal terminal 227. In this case, the operating parameter of the power connector 2 further includes the first negative voltage and the second negative voltage.

Further, the first male negative signal terminal 226 is configured to output the first negative voltage to the first female negative signal terminal 406. The second male negative signal terminal 227 is configured to output the second negative voltage to the second female negative signal terminal 407. In this case, the connection status of the power connector 2 further includes the connection status between the negative power terminal 21 and the negative conducting wire 31. The first negative voltage and the second negative voltage are for determining a negative voltage drop at the second connection position b. For example, the negative voltage drop may be a voltage difference between the first negative voltage and the second negative voltage, or the negative voltage drop may be an amplified negative voltage drop obtained by amplifying a voltage difference between the first negative voltage and the second negative voltage.

When the negative voltage drop is greater than or equal to a fifth threshold, the connection status between the negative power terminal 21 and the negative conducting wire 31 is an abnormal state. That is, in this case, the negative power terminal 21 is in poor contact with the negative conducting wire 31.

Through implementation of this embodiment of this application, because the negative voltage drop at the second connection position b increases when the negative power terminal 21 is in poor contact with the negative conducting wire 31, whether the negative power terminal 21 is in poor contact with the negative conducting wire 31 can be identified in advance by detecting the first negative voltage and the second negative voltage. In addition, there is no need to wait for a heat accumulation process at the second connection position b, a speed of the abnormality detection on the negative pole side is faster, and the security is higher.

It may be understood that both the manner of the abnormality detection on the positive pole side and the manner of the abnormality detection on the negative pole side may be used. For example, when one of the case in which the negative voltage drop is greater than or equal to the fifth threshold and the case in which the positive voltage drop is greater than or equal to the fourth threshold occurs, or both cases occur, it may be determined that the power connector 2 is in poor contact with the power cable 3. A specific requirement may be designed based on an actual case. This is not limited in this application.

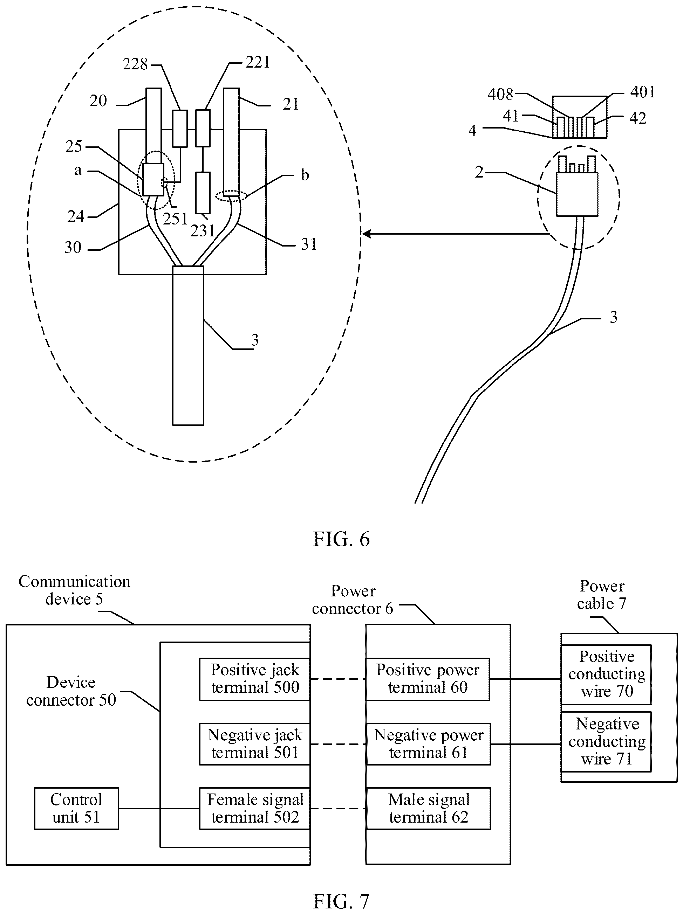

In some feasible implementations, as shown in FIG. 6, the power connector 2 shown in FIG. 3 further includes a switch 25. For example, the switch 25 may be a relay, a contactor, or a bidirectional switch. The male signal terminal 22 includes a male switch signal terminal 228, and the female signal terminal 40 includes a female switch signal terminal 408. The switch 25 is disposed between the first end of the positive power terminal 20 and the positive conducting wire 30. Optionally, the switch 25 may alternatively be disposed between the first end of the negative power terminal 21 and the negative conducting wire 31. A control end 251 of the switch 25 is connected to a first end of the male switch signal terminal 228. Specifically, the control end 251 of the switch 25 is connected to the first end of the male switch signal terminal 228 through a signal line. A second end of the male switch signal terminal 228 is configured to connect to the female switch signal terminal 408.

When the power cable 3 is connected to the external power supply, the male switch signal terminal 228 is configured to receive a high-level signal from the female switch signal terminal 408. The high-level signal is for controlling the switch 25 to be turned on, to conduct a passage of current between the power supply and the power connector 2, so that the power connector 2 supplies power to current-using equipment. However, after a device corresponding to the device connector 4 detects that the connection status of the power connector 2 is the abnormal state, the male switch signal terminal 228 is configured to receive a low-level signal from the female switch signal terminal 408, where the low-level signal is for controlling the switch 25 to be turned off. In this case, no current flows through the power connector 2. In this way, further rising of the temperature at the first connection position a and the temperature at the second connection position b can be avoided, so that it is ensured that further heat-induced carbonization does not occur on the power connector 2, and security is higher. It may be understood that, the low-level signal may alternatively be configured to control the switch 25 to be turned on. This is not limited in this application. In other words, the male switch signal terminal 228 is configured to receive a signal from the female switch signal terminal 408, and the signal may be for controlling the switch 25 to be turned on.

In some feasible implementations, the switch 25 and the male switch signal terminal 228 may alternatively be disposed in the power connector 2 shown in FIG. 4 or FIG. 5, and the female switch signal terminal 408 may alternatively be correspondingly disposed in the device connector 4 shown in FIG. 4 or FIG. 5.

In some feasible implementations, as shown in FIG. 3 to FIG. 6, the device connector 4 further includes a positive jack terminal 41 and a negative jack terminal 42. The positive power terminal 20 is configured to be plugged into the positive jack terminal 41, and the negative power terminal 21 is configured to be plugged into the negative jack terminal 42. In this case, the power connector 2 may output electric energy to the device connector 4, so that the device corresponding to the device connector 4 operates.

In the embodiments corresponding to FIG. 3 to FIG. 6, any one of the first threshold, the second threshold, the third threshold, the fourth threshold, and the fifth threshold may be a preset value, or a value determined based on a component used in the power connector 2.

With reference to FIG. 7 to FIG. 12, the following describes, by using examples, a communication device provided in embodiments of this application and an operating principle of the communication device.

FIG. 7 is a block diagram of a structure of a communication device according to an embodiment of this application. As shown in FIG. 7, the communication device 5 includes a device connector 50 and a control unit 51, where the device connector 50 includes a positive jack terminal 500, a negative jack terminal 501, and a female signal terminal 502, the positive jack terminal 500 is configured for a positive power terminal 60 in a power connector 6 to be plugged into, and the negative jack terminal 501 is configured for a negative power terminal 61 in the power connector 6 to be plugged into. A first end of the female signal terminal 502 is configured to connect to a male signal terminal 62 in the power connector 6, and a second end of the female signal terminal 502 is connected to the control unit 51 through a signal line. For example, the device connector 50 and the power connector 6 are respectively the device connector 4 and the power connector 2 shown in FIG. 2. In this case, for related descriptions of structures of the female signal terminal 502 and the male signal terminal 62, refer to the embodiment corresponding to FIG. 2. Details are not described herein again.

The female signal terminal 502 is configured to: receive an operating parameter of the power connector 6 from the male signal terminal 62, and output the operating parameter to the control unit 51, where the operating parameter may be a temperature or a voltage, and is obtained by a sampling unit inside the power connector 6 through detection.

Further, the control unit 51 is configured to determine, based on the operating parameter, whether a connection status of the power connector 6 is an abnormal state. The connection status of the power connector 6 includes at least one of a connection status between the positive power terminal 60 and a positive conducting wire 70 in a power cable 7 and a connection status between the negative power terminal 61 and a negative conducting wire 71 in the power cable 7.

Through implementation of this embodiment of this application, whether the connection status of the power connector 6 is the abnormal state is identified in advance based on the operating parameter of the power connector 6. In this way, heat-induced carbonization of the power connector 6 or even burnout of the communication device 5 can be avoided, so that usage security of the communication device 5 is improved.

In some feasible implementations, when one of the connection status between the positive power terminal 60 and the positive conducting wire 70 and the connection status between the negative power terminal 61 and the negative conducting wire 71 is an abnormal state, or both connection statuses are abnormal states, it may be determined that the connection status of the power connector 6 is the abnormal state. A specific requirement may be designed based on an actual case. This is not limited in this application.

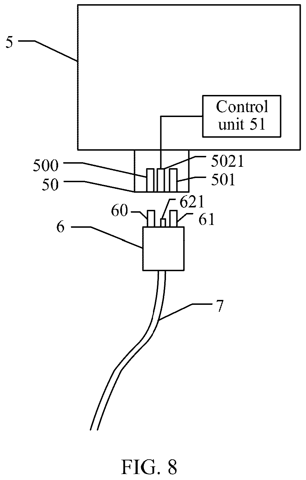

In some feasible implementations, as shown in FIG. 8, the female signal terminal 502 shown in FIG. 7 is a female signal terminal 5021, and the male signal terminal 62 is a male signal terminal 621. The female signal terminal 5021 is configured to: receive a temperature at any position between a first connection position and a second connection position from the male signal terminal 621, and output the temperature at the any position to the control unit 51, where the first connection position is a connection position between the positive power terminal 60 and the positive conducting wire 70, and the second connection position is a connection position between the negative power terminal 61 and the negative conducting wire 71. The temperature at the any position may be obtained by the sampling unit inside the power connector 6 through detection. For example, a specific structure of the sampling unit is shown in FIG. 3. In addition, the temperature at the any position is close to a higher temperature in a temperature at the first connection position and a temperature at the second connection position.

Further, the control unit 51 is configured to determine whether the connection status of the power connector 6 is the abnormal state, where the abnormal state includes that the temperature at the any position is greater than or equal to a first threshold. In this case, the power connector 6 is in poor contact with the power cable 7. In other words, the control unit 51 is configured to: in response to the temperature at the any position being greater than or equal to the first threshold, determine that the power connector 6 is in poor contact with the power cable 7; and in response to the temperature at the any position being less than the first threshold, determine that the power connector 6 is in good contact with the power cable 7.

Through implementation of this embodiment of this application, because a local temperature near at least one of the first connection position and the second connection position rises when the power connector 6 is in poor contact with the power cable 7, whether the connection status of the power connector 2 is the abnormal state is detected based on the temperature at the any position. In this way, abnormality detection accuracy can be improved, so that the usage security of the communication device 5 is improved.

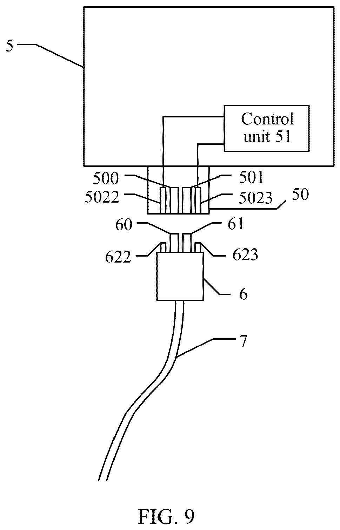

In some feasible implementations, as shown in FIG. 9, the female signal terminal 502 shown in FIG. 7 includes a female positive signal terminal 5022 and a female negative signal terminal 5023, and the male signal terminal 62 includes a male positive signal terminal 622 and a male negative signal terminal 623. The female positive signal terminal 5022 is configured to connect to the male positive signal terminal 622. Specifically, a first end of the female positive signal terminal 5022 is configured to connect to the male positive signal terminal 622. The female negative signal terminal 5023 is configured to connect to the male negative signal terminal 623. Specifically, a first end of the female negative signal terminal 5023 is configured to connect to the male negative signal terminal 623. A second end of the female positive signal terminal 5022 and a second end of the female negative signal terminal 5023 are connected to the control unit 51 through signal lines.

The following describes a manner that is of abnormality detection on a positive pole side and that corresponds to FIG. 9.

The female positive signal terminal 5022 is configured to: receive a first temperature from the male positive signal terminal 622, and output the first temperature to the control unit 51, where the first temperature is close to a temperature at a first connection position. In this case, the operating parameter of the power connector 6 includes the first temperature at any position on a side that is of the first connection position and that faces away from a second connection position. Further, the control unit 51 is configured to determine whether the connection status between the positive power terminal 60 and the positive conducting wire 70 is the abnormal state, where the abnormal state includes that the first temperature is greater than or equal to a second threshold. In this case, the positive power terminal 60 is in poor contact with the positive conducting wire 70. In other words, the control unit 51 is configured to: in response to the first temperature being greater than or equal to the second threshold, determine that the positive power terminal 60 is in poor contact with the positive conducting wire 70; and in response to the first temperature being less than the second threshold, determine that the positive power terminal 60 is in good contact with the positive conducting wire 70.

Through implementation of this embodiment of this application, because a local temperature near the first connection position rises when the positive power terminal 60 is in poor contact with the positive conducting wire 70, whether the connection status between the positive power terminal 60 and the positive conducting wire 70 is the abnormal state is detected based on the first temperature. In this way, accuracy of the abnormality detection on the positive pole side can be improved, so that the usage security of the communication device 5 is improved.

The following describes a manner that is of abnormality detection on a negative pole side and that corresponds to FIG. 9.

The female negative signal terminal 5023 is configured to: receive a second temperature from the male negative signal terminal 623, and output the second temperature to the control unit 51, where the second temperature is close to a temperature at the second connection position. In this case, the operating parameter of the power connector 6 further includes the second temperature at any position on a side that is of the second connection position and that faces away from the first connection position. Further, the control unit 51 is configured to determine whether the connection status between the negative power terminal 61 and the negative conducting wire 71 is the abnormal state, where the abnormal state includes that the second temperature is greater than or equal to a third threshold. In this case, the negative power terminal 61 is in poor contact with the negative conducting wire 71. In other words, the control unit 51 is configured to: in response to the second temperature being greater than or equal to the third threshold, determine that the negative power terminal 61 is in poor contact with the negative conducting wire 71; and in response to the second temperature being less than the third threshold, determine that the negative power terminal 61 is in good contact with the negative conducting wire 71. The second threshold may be equal or unequal to the third threshold. This is not limited in this application.

Through implementation of this embodiment of this application, a local temperature near the second connection position rises when the negative power terminal 61 is in poor contact with the negative conducting wire 71, whether the connection status between the negative power terminal 61 and the negative conducting wire 71 is the abnormal state is detected based on the second temperature. In this way, accuracy of the abnormality detection on the negative pole side can be improved, so that the usage security of the communication device 5 is improved. In addition, both the abnormality detection on the positive pole side and the abnormality detection on the negative pole side can be considered, and a detection manner is more flexible and comprehensive.

In the implementations corresponding to FIG. 9, the first temperature and the second temperature may be obtained by the sampling unit inside the power connector 6 through detection. For example, a specific structure of the sampling unit is shown in FIG. 4.

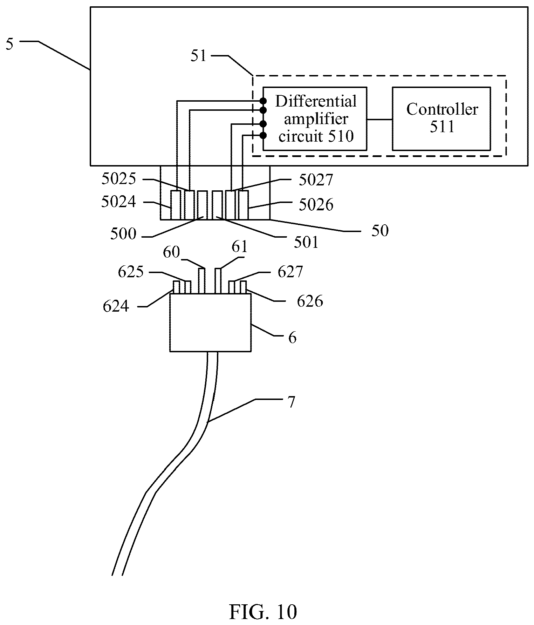

In some feasible implementations, as shown in FIG. 10, the female signal terminal 502 shown in FIG. 7 includes a first female positive signal terminal 5024, a second female positive signal terminal 5025, a first female negative signal terminal 5026, and a second female negative signal terminal 5027. The male signal terminal 62 shown in FIG. 7 includes a first male positive signal terminal 624, a second male positive signal terminal 625, a first male negative signal terminal 626, and a second male negative signal terminal 627. The control unit 51 includes a differential amplifier circuit 510 and a controller 511. For example, the controller 511 may be a processing chip inside the communication device 5. The differential amplifier circuit 510 and the controller 511 may be separately disposed. In this case, the differential amplifier circuit 510 may be disposed inside or outside the control unit 51. When the differential amplifier circuit 510 is disposed outside the control unit 51, the controller 511 is the control unit 51. Optionally, the differential amplifier circuit 510 may alternatively be integrated inside the controller 511. A specific position of the differential amplifier circuit 510 is not limited herein.

A first end of the first female positive signal terminal 5024 is configured to connect to the first male positive signal terminal 624, and a second end of the first female positive signal terminal 5024 is connected to a first positive input end of the differential amplifier circuit 510. For example, the second end of the first female positive signal terminal 5024 is connected to the first positive input end of the differential amplifier circuit 510 through a signal line. A first end of the second female positive signal terminal 5025 is configured to connect to the second male positive signal terminal 625, and a second end of the second female positive signal terminal 5025 is connected to a second positive input end of the differential amplifier circuit 510. For example, the second end of the second female positive signal terminal 5025 is connected to the second positive input end of the differential amplifier circuit 510 through a signal line.

A first end of the first female negative signal terminal 5026 is configured to connect to the first male negative signal terminal 626, and a second end of the first female negative signal terminal 5026 is connected to a first negative input end of the differential amplifier circuit 510. For example, the second end of the first female negative signal terminal 5026 is connected to the first negative input end of the differential amplifier circuit 510 through a signal line. A first end of the second female negative signal terminal 5027 is configured to connect to the second male negative signal terminal 627, and a second end of the second female negative signal terminal 5027 is connected to a second negative input end of the differential amplifier circuit 510. For example, the second end of the second female negative signal terminal 5027 is connected to the second negative input end of the differential amplifier circuit 510 through a signal line. An output end of the differential amplifier circuit 510 is connected to the controller 511 through a signal line.

The following describes a manner that is of abnormality detection on a positive pole side and that corresponds to FIG. 10.

The first female positive signal terminal 5024 is configured to: receive a first positive voltage of the positive conducting wire 70 from the first male positive signal terminal 624, and output the first positive voltage to the differential amplifier circuit 510. The second female positive signal terminal 5025 is configured to: receive a second positive voltage of the positive power terminal 60 from the second male positive signal terminal 625, and output the second positive voltage to the differential amplifier circuit 510. In this case, the operating parameter of the power connector 6 includes the first positive voltage and the second positive voltage.

Further, the differential amplifier circuit 510 is configured to: amplify a voltage difference between the first positive voltage and the second positive voltage to obtain an amplified positive voltage drop at a first connection position, and output the amplified positive voltage drop to the controller 511. The voltage difference between the first positive voltage and the second positive voltage is a positive voltage drop at the first connection position.

Still further, the controller 511 is configured to determine whether the connection status between the positive power terminal 60 and the positive conducting wire 70 is the abnormal state, where the abnormal state includes that the amplified positive voltage drop is greater than or equal to a fourth threshold. In this case, the positive power terminal 60 is in poor contact with the positive conducting wire 70. In other words, the controller 511 is configured to: in response to the amplified positive voltage drop being greater than or equal to the fourth threshold, determine that the positive power terminal 60 is in poor contact with the positive conducting wire 70; and in response to the amplified positive voltage drop being less than the fourth threshold, determine that the positive power terminal 60 is in good contact with the positive conducting wire 70.

Through implementation of this embodiment of this application, because the positive voltage drop at the first connection position increases but by a small value when the positive power terminal 60 is in poor contact with the positive conducting wire 70, the differential amplifier circuit 510 can better detect a change process of the positive voltage drop after amplifying the positive voltage drop. In addition, there is no need to wait for a heat accumulation process at the first connection position, to quickly identify whether the connection status between the positive power terminal 60 and the positive conducting wire 70 is the abnormal state, so that accuracy and a speed of the abnormality detection on the positive pole side can be improved, and the usage security of the communication device 5 is improved.

The following describes a manner that is of abnormality detection on a negative pole side and that corresponds to FIG. 10.

The first female negative signal terminal 5026 is configured to: receive a first negative voltage of the negative conducting wire 71 from the first male negative signal terminal 626, and output the first negative voltage to the differential amplifier circuit 510. The second female negative signal terminal 5027 is configured to: receive a second negative voltage of the negative power terminal 61 from the second male negative signal terminal 527, and output the second negative voltage to the differential amplifier circuit 510. In this case, the operating parameter of the power connector 6 further includes the first negative voltage and the second negative voltage.

Further, the differential amplifier circuit 510 is configured to: amplify a voltage difference between the first negative voltage and the second negative voltage to obtain an amplified negative voltage drop at a second connection position, and output the amplified negative voltage drop to the controller 511. The voltage difference between the first negative voltage and the second negative voltage is a negative voltage drop at the second connection position.

Still further, the controller 511 is configured to determine whether the connection status between the negative power terminal 61 and the negative conducting wire 71 is the abnormal state, where the abnormal state includes that the amplified negative voltage drop is greater than or equal to a sixth threshold. In this case, the negative power terminal 61 is in poor contact with the negative conducting wire 71. In other words, the controller 511 is configured to: in response to the amplified negative voltage drop being greater than or equal to the sixth threshold, determine that the negative power terminal 61 is in poor contact with the negative conducting wire 71; and in response to the amplified negative voltage drop being less than the sixth threshold, determine that the negative power terminal 61 is in good contact with the negative conducting wire 71.

Through implementation of this embodiment of this application, because the negative voltage drop at the second connection position increases but by a small value when the negative power terminal 61 is in poor contact with the negative conducting wire 71, the differential amplifier circuit 510 can better detect a change process of the negative voltage drop after amplifying the negative voltage drop. In addition, there is no need to wait for a heat accumulation process at the second connection position, to quickly identify whether the connection status between the negative power terminal 61 and the negative conducting wire 71 is the abnormal state, so that accuracy and a speed of the abnormality detection on the negative pole side can be improved, and the usage security of the communication device 5 is improved. In addition, both the abnormality detection on the positive pole side and the abnormality detection on the negative pole side can be considered, and a detection manner is more flexible and comprehensive.

In the implementations corresponding to FIG. 10, the first positive voltage, the second positive voltage, the first negative voltage, and the second negative voltage may be obtained by the sampling unit inside the power connector 6 through detection. For example, a specific structure of the sampling unit is shown in FIG. 5.

Optionally, in some feasible implementations, when the controller 511 may directly detect the change processes of the positive voltage drop and the negative voltage drop, the differential amplifier circuit 510 may alternatively not be disposed inside the control unit 51. In this case, the controller 511 may compare the positive voltage drop with a preset positive voltage drop threshold, to determine whether the connection status between the positive power terminal 60 and the positive conducting wire 70 is the abnormal state; and compare the negative voltage drop with a preset negative voltage drop threshold, to determine whether the connection status between the negative power terminal 61 and the negative conducting wire 71 is the abnormal state. For specific implementation, refer to the manners that are of the abnormality detection on the positive pole side and the negative pole side and that correspond to FIG. 10. Details are not described herein again. The preset positive voltage drop threshold is less than the fourth threshold, and the preset negative voltage drop threshold is less than the sixth threshold.

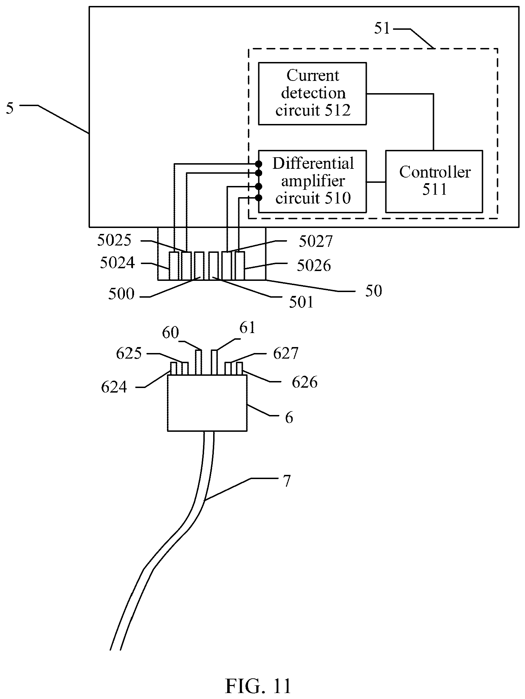

In some feasible implementations, as shown in FIG. 11, the control unit 51 shown in FIG. 10 may further include a current detection circuit 512, where the current detection circuit 512 and the controller 511 may be separately disposed. In this case, the current detection circuit 512 may be disposed inside or outside the control unit 51. Optionally, the current detection circuit 512 may alternatively be integrated inside the controller 511. A specific position of the current detection circuit 512 is not limited herein.

The following describes a manner that is of abnormality detection on a positive pole side and that corresponds to FIG. 11.

The current detection circuit 512 is configured to: detect a current of the positive jack terminal 500, and output the current of the positive jack terminal 500 to the controller 511. Because a value of a current basically remains unchanged in a process in which the positive conducting wire 70 outputs the current to the positive jack terminal 500 through the positive power terminal 60, the current of the positive jack terminal 500 is the same as a current at the first connection position.

Further, the controller 511 is configured to: obtain amplified positive impedance at the first connection position based on the amplified positive voltage drop and the current of the positive jack terminal 500, and determine whether the connection status between the positive power terminal 60 and the positive conducting wire 70 is the abnormal state, where the abnormal state includes that the amplified positive impedance is greater than or equal to a fifth threshold. In this case, the positive power terminal 60 is in poor contact with the positive conducting wire 70. In other words, the controller 511 is configured to: in response to the amplified positive impedance being greater than or equal to the fifth threshold, determine that the positive power terminal 60 is in poor contact with the positive conducting wire 70; and in response to the amplified positive impedance being less than the fifth threshold, determine that the positive power terminal 60 is in good contact with the positive conducting wire 70.

Through implementation of this embodiment of this application, because positive impedance at the first connection position increases but by a small value when the positive power terminal 60 is in poor contact with the positive conducting wire 70, a change process of the positive impedance can be better detected after the amplified positive impedance is obtained based on the amplified positive voltage drop and the current of the positive jack terminal 500. In addition, there is no need to wait for the heat accumulation process at the first connection position, to quickly identify whether the connection status between the positive power terminal 60 and the positive conducting wire 70 is the abnormal state, so that accuracy and a speed of the abnormality detection on the positive pole side is improved, and the usage security of the communication device 5 is improved.

The following describes a manner that is of abnormality detection on a negative pole side and that corresponds to FIG. 11.

The current detection circuit 512 is configured to: detect a current of the negative jack terminal 501, and output the current of the negative jack terminal 501 to the controller 511. Because a value of a current basically remains unchanged in a process in which the negative conducting wire 71 outputs the current to the negative jack terminal 501 through the negative power terminal 61, the current of the negative jack terminal 501 is the same as a current at the second connection position.

Further, the controller 511 is configured to: obtain amplified negative impedance at the second connection position based on the amplified negative voltage drop and the current of the negative jack terminal 501, and determine whether the connection status between the negative power terminal 61 and the negative conducting wire 71 is the abnormal state, where the abnormal state includes that the amplified negative impedance is greater than or equal to a seventh threshold. In this case, the negative power terminal 61 is in poor contact with the negative conducting wire 71. In other words, the controller 511 is configured to: in response to the amplified negative impedance being greater than or equal to the seventh threshold, determine that the negative power terminal 61 is in poor contact with the negative conducting wire 71; and in response to the amplified negative impedance being less than the seventh threshold, determine that the negative power terminal 61 is in good contact with the negative conducting wire 71.

Through implementation of this embodiment of this application, because negative impedance at the second connection position increases but by a small value when the negative power terminal 61 is in poor contact with the negative conducting wire 71, a change process of the negative impedance can be better detected after the amplified negative impedance is obtained based on the amplified negative voltage drop and the current of the negative jack terminal 501. In addition, there is no need to wait for the heat accumulation process at the second connection position, to quickly identify whether the connection status between the negative power terminal 61 and the negative conducting wire 71 is the abnormal state, so that accuracy and a speed of the abnormality detection on the negative pole side can be improved, and the usage security of the communication device 5 is improved. In addition, both the abnormality detection on the positive pole side and the abnormality detection on the negative pole side can be considered, and a detection manner is more flexible and comprehensive.

Optionally, in some feasible implementations, when the controller 511 may directly detect the change process of the negative voltage drop, the differential amplifier circuit 510 may alternatively not be disposed inside the control unit 51. In this case, the controller 511 is configured to: obtain the positive impedance at the first connection position based on the positive voltage drop and the current of the positive jack terminal 500, and compare the positive impedance with a preset positive impedance threshold, to determine whether the connection status between the positive power terminal 60 and the positive conducting wire 70 is the abnormal state. For specific implementation, refer to the manner that is of the abnormality detection on the positive pole side and that corresponds to FIG. 11. Details are not described herein again. The preset positive impedance threshold is less than the fifth threshold. The controller 511 is further configured to: obtain the negative impedance at the second connection position based on the negative voltage drop and the current of the negative jack terminal 501, and compare the negative impedance with a preset negative impedance threshold, to determine whether the connection status between the negative power terminal 61 and the negative conducting wire 71 is the abnormal state. For specific implementation, refer to the manner that is of the abnormality detection on the negative pole side and that corresponds to FIG. 11. Details are not described herein again. The preset negative impedance threshold is less than the seventh threshold.

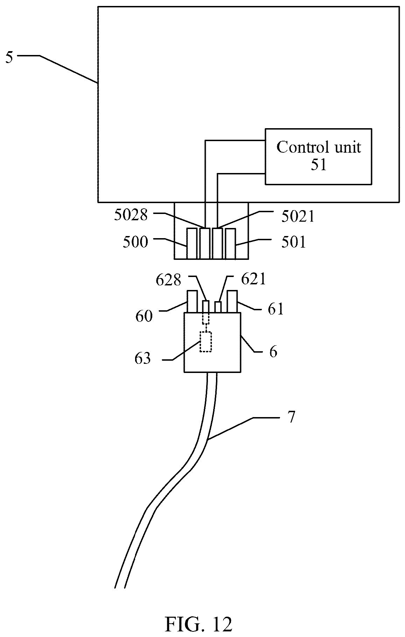

In some feasible implementations, as shown in FIG. 12, the female signal terminal 502 shown in FIG. 7 includes a female switch signal terminal 5028, and the male signal terminal 62 includes a male switch signal terminal 628. The female switch signal terminal 5028 is configured to connect to the male switch signal terminal 628. For example, a first end of the female switch signal terminal 5028 is configured to connect to the male switch signal terminal 628, and a second end of the female switch signal terminal 5028 is connected to the control unit 51 through a signal line.

When an external power supply supplies power to the communication device 5, the control unit 51 is configured to output a high-level signal to the female switch signal terminal 5028. Further, the female switch signal terminal 5028 is configured to output the high-level signal to the male switch signal terminal 628. The high-level signal is for controlling a switch 63 in the power connector 6 to be turned on, so that the external power supply supplies the power to the communication device 5 through the power connector 6. In a process of supplying the power to the communication device 5, the control unit 51 is configured to output a low-level signal to the female switch signal terminal 5028 after identifying that the connection status of the power connector 6 is the abnormal state. For example, after the connection status of the power connector 6 is the abnormal state, a temperature at at least one of a first connection position and a second connection position further continuously rises. In this case, the control unit 51 is configured to output the low-level signal to the female switch signal terminal 5028 in response to any one of a temperature at any position between the first connection position and the second connection position, a first temperature, or a second temperature that being greater than or equal to a preset temperature threshold. The preset temperature threshold is greater than any one of the first threshold, the second threshold, and the third threshold. It may be understood that, for the power connector 6 in FIG. 12, refer to the descriptions of the power connector 2 in FIG. 6. Specifically, for a technical solution related to the switch 63, refer to the descriptions related to the switch 25 in FIG. 6.

Further, the female switch signal terminal 5028 is configured to output the low-level signal to the male switch signal terminal 628, where the low-level signal is for controlling the switch 63 in the power connector 6 to be turned off; and the switch 63 is disposed between the positive power terminal 60 and the positive conducting wire 70, or the switch 63 is disposed between the negative power terminal 61 and the negative conducting wire 71. In this case, no current flows through the power connector 6, so that further rising of a temperature at the first connection position and a temperature at the second connection position can be avoided, to protect the communication device 5 from burnout. Similar to the foregoing descriptions, in product implementation, the switch may be controlled, by using the low-level signal based on an actual requirement, to be turned off. This is not limited in this application.

Optionally, in some feasible implementations, the control unit 51 is configured to: after the connection status of the power connector 6 is the abnormal state, control power consumption of the communication device 5 to be reduced. For example, the control unit 51 is configured to control a part of data transmission channels inside the communication device 5 to be shut down, to reduce the power consumption of the communication device 5, so that further rising of the temperature at the first connection position and the temperature at the second connection position can be avoided, to protect the communication device 5 from burnout.

In some feasible implementations, the female switch signal terminal 5028 may alternatively be disposed in the device connector 50 shown in FIG. 10 or FIG. 11, and the switch 63 and the male switch signal terminal 628 may alternatively be correspondingly disposed in the power connector 6 shown in FIG. 10 or FIG. 11.

In some feasible implementations, the control unit 51 or the controller 511 is configured to output alarm information to a user interface in response to the connection status of the power connector 6 being the abnormal state. The user interface may be a display interface corresponding to a user end at which operations and maintenance personnel is located. The alarm information includes at least one abnormal operating parameter in the temperature at the any position between the first connection position and the second connection position, the first temperature, the second temperature, the amplified positive voltage drop or the positive voltage drop, the amplified negative voltage drop or the negative voltage drop, the amplified positive impedance or the positive impedance, or the amplified negative impedance or the negative impedance. This may be specifically determined by an actual structure of the power connector 6, and is not limited herein. In addition, the alarm information indicates the operations and maintenance personnel to repair the power connector 6, to enable the connection status of the power connector 6 to be restored from the abnormal state to a normal state, so that reliability of the power connector 6 is improved, and the usage security of the communication device 5 is improved.

In the embodiments corresponding to FIG. 7 to FIG. 12, any one of the first threshold, the second threshold, the third threshold, the fourth threshold, the fifth threshold, the sixth threshold, the seventh threshold, the preset positive voltage drop threshold, the preset negative voltage drop threshold, the preset positive impedance threshold, the preset negative impedance threshold, and the preset temperature threshold may be a preset value, or a value determined based on a component used in the power connector 6. The thresholds may be any values, and may be equal or unequal. This is not limited in this application.

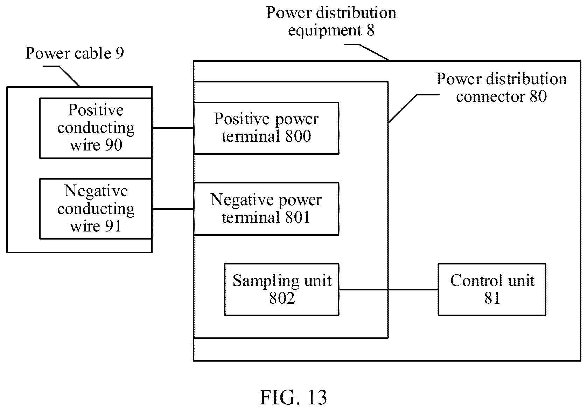

With reference to FIG. 13 to FIG. 17, the following describes, by using examples, power distribution equipment provided in embodiments of this application and an operating principle of the power distribution equipment.

FIG. 13 is a block diagram of a structure of power distribution equipment according to an embodiment of this application. As shown in FIG. 13, the power distribution equipment 8 includes a power distribution connector 80 and a control unit 81, where the power distribution connector 80 includes a positive power terminal 800, a negative power terminal 801, and a sampling unit 802, a first end of the positive power terminal 800 is configured to connect to a positive conducting wire 90 in a power cable 9, and a first end of the negative power terminal 801 is configured to connect to a negative conducting wire 91 in the power cable 9.

The sampling unit 802 is configured to: detect an operating parameter of the power distribution connector 80, and output the operating parameter to the control unit 81. The operating parameter may be one of a temperature or a voltage. Further, the control unit 81 is configured to determine, based on the operating parameter, whether a connection status of the power distribution connector 80 is an abnormal state. The connection status of the power distribution connector 80 includes at least one of a connection status between the positive power terminal 800 and the positive conducting wire 90 and a connection status between the negative power terminal 801 and the negative conducting wire 91.

Through implementation of this embodiment of this application, whether the connection status of the power distribution connector 80 is the abnormal state is identified in advance by detecting the operating parameter of the power distribution connector 80. In this way, heat-induced carbonization of the power distribution connector 80 or even burnout of the power distribution equipment 8 can be avoided, so that reliability of the power distribution connector 80 is improved, and power supply security of the power distribution equipment 8 is improved.

In some feasible implementations, when one of the connection status between the positive power terminal 800 and the positive conducting wire 90 and the connection status between the negative power terminal 801 and the negative conducting wire 91 is an abnormal state, or both connection statuses are abnormal states, it may be determined that the connection status of the power distribution connector 80 is the abnormal state. A specific requirement may be designed based on an actual case. This is not limited in this application.

In some feasible implementations, the power distribution connector 80 and the control unit 81 may be separately disposed, or the control unit 81 may be integrated inside the power distribution connector 80. A specific position of the control unit 81 is not limited herein. For ease of description, the following uses an example in which the control unit 81 is integrated inside the power distribution connector 80 for description.

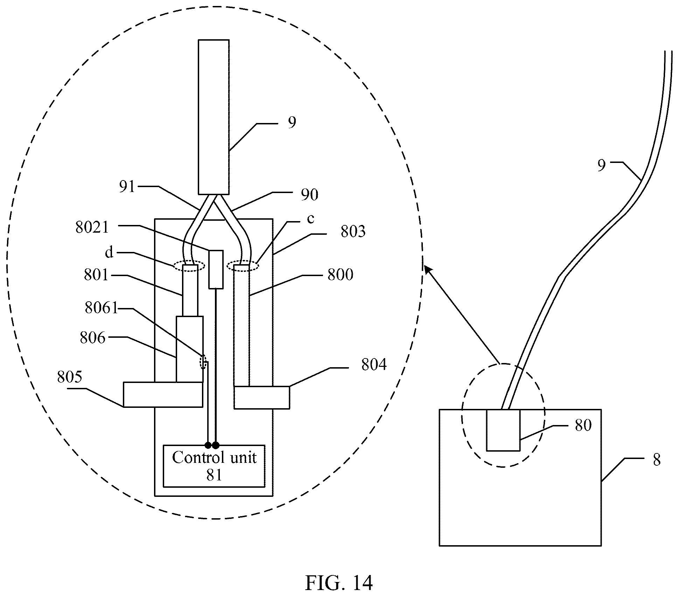

In some feasible implementations, as shown in FIG. 14, the sampling unit 802 shown in FIG. 13 includes a temperature detection element 8021. The temperature detection element 8021 is disposed between a first connection position c and a second connection position d. The first connection position c is a connection position between the positive power terminal 800 and the positive conducting wire 90, and the second connection position d is a connection position between the negative power terminal 801 and the negative conducting wire 91. As shown in FIG. 13, a connector shell 803 is further included. The positive power terminal 800, the negative power terminal 801, and the temperature detection element 8021 are all disposed inside the connector shell 803. The temperature detection element 8021 is connected to the control unit 81 through a signal line.

The temperature detection element 8021 is configured to detect a temperature at a position of the temperature detection element 8021. In this case, the operating parameter of the power distribution connector 80 is the temperature at the position of the temperature detection element 8021. The temperature at the position of the temperature detection element 231 is close to a higher temperature in a temperature at the first connection position c and a temperature at the second connection position d.

Further, the control unit 81 is configured to determine whether the connection status of the power distribution connector 80 is the abnormal state, where the abnormal state includes that the temperature at the position of the temperature detection element 8021 is greater than or equal to a first threshold. In this case, the power distribution connector 80 is in poor contact with the power cable 9. In other words, the control unit 81 is configured to: in response to the temperature at the position of the temperature detection element 8021 being greater than or equal to the first threshold, determine that the power distribution connector 80 is in poor contact with the power cable 9; and in response to the temperature at the position of the temperature detection element 8021 being less than the first threshold, determine that the power distribution connector 80 is in good contact with the power cable 9.

Through implementation of this embodiment of this application, because a local temperature near at least one of the first connection position c and the second connection position d rises when the power distribution connector 80 is in poor contact with the power cable 9, whether the power distribution connector 80 is in poor contact with the power cable 9 is identified in advance by detecting the temperature at the position of the temperature detection element 8021. In this way, a most accurate detection feedback effect can be achieved, and costs are lower.

In some feasible implementations, as shown in FIG. 14, the power distribution connector 80 shown in FIG. 13 further includes a positive conductor 804, a negative conductor 805, and a switch 806. For example, the switch 806 may be one of a relay, a contactor, and a bidirectional switch. A third end of the positive power terminal 800 is connected to a first end of the positive conductor 804, and a second end of the positive conductor 804 is configured to connect to a positive pole of an external power supply. For example, the second end of the positive conductor 804 is configured to pass through the connector shell 803 to connect to the positive pole of the external power supply, and the positive conductor 804 may also be referred to as a positive pre-stage conductor. A third end of the negative power terminal 801 is connected to a first end of the negative conductor 805, and a second end of the negative conductor 805 is configured to connect to a negative pole of the external power supply. For example, the second end of the negative conductor 805 is configured to pass through the connector shell 803 to connect to the negative pole of the external power supply, and the negative conductor 805 may also be referred to as a negative pre-stage conductor. The switch 806 may be disposed between the third end of the negative power terminal 801 and the first end of the negative conductor 805. Optionally, the switch 806 may alternatively be disposed between the third end of the positive power terminal 800 and the first end of the positive conductor 804. This is not specifically limited herein. A control end 8061 of the switch 806 is connected to the control unit 81 through a signal line. Therefore, the control unit 81 may control the switch 806 to be turned on or turned off.

When the external power supply supplies power to the power distribution connector 80, the control unit 81 is configured to control the switch 806 to be turned on, so that the power distribution equipment 80 supplies power to current-using equipment through the power cable 9. For example, the current-using equipment may be the communication device 5 shown in FIG. 7 to FIG. 12. In a process in which the power distribution equipment 80 supplies the power to the current-using equipment, the control unit 81 is configured to: after identifying that the connection status of the power distribution connector 80 is the abnormal state, control the switch 806 to be turned off. During specific implementation, after the connection status of the power distribution connector 80 is the abnormal state, a temperature at at least one of the first connection position c and the second connection position d further continuously rises. In this case, the control unit 51 is configured to: in response to the temperature at the position of the temperature detection element 8021 being greater than or equal to a first preset temperature threshold, control the switch 806 to be turned off. The first preset temperature threshold is greater than the first threshold.

Through implementation of this embodiment of this application, after the connection status of the power distribution connector 80 is the abnormal state, no current flows through the power distribution connector 80. In this way, further rising of the temperature at the first connection position c and the temperature at the second connection position d can be avoided, so that the power distribution equipment 8 is protected from burnout, and security is higher.

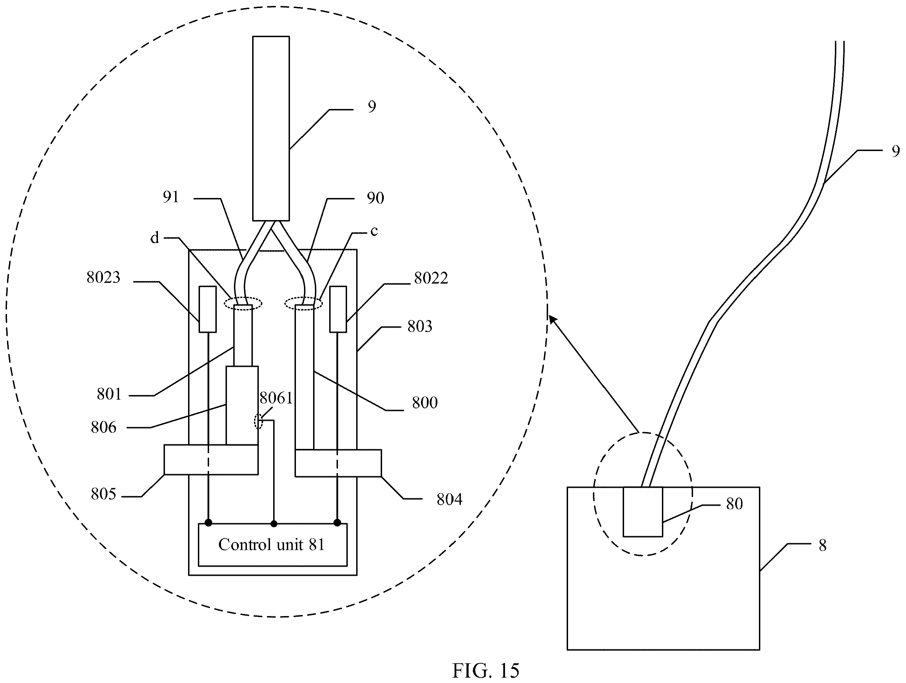

In some feasible implementations, as shown in FIG. 15, the sampling unit 802 shown in FIG. 13 includes a first temperature detection element 8022 and a second temperature detection element 8023. The first temperature detection element 8022 is disposed on a side that is of a first connection position c and that faces away from a second connection position d, and the second temperature detection element 8023 is disposed on a side that is of the second connection position d and that faces away from the first connection position c. As shown in FIG. 13, a connector shell 803 is further included. The positive power terminal 800, the negative power terminal 801, the first temperature detection element 8022, and the second temperature detection element 8023 are all disposed inside the connector shell 803. The first temperature detection element 8022 is connected to the control unit 51 through a signal line, and the second temperature detection element 8023 is connected to the control unit 51 through a signal line.

The first temperature detection element 8022 is configured to: detect a first temperature at a position of the first temperature detection element 8022, and output the first temperature to the control unit 81, where the first temperature is close to a temperature at the first connection position c. The second temperature detection element is configured to: detect a second temperature at a position of the second temperature detection element 8023, and output the second temperature to the control unit 81, where the second temperature is close to a temperature at the second connection position d. In this case, the operating parameter of the power distribution connector 80 includes the first temperature and the second temperature.

Further, the control unit 81 is configured to determine whether the connection status between the positive power terminal 800 and the positive conducting wire 90 is the abnormal state, where the abnormal state includes that the first temperature is greater than or equal to a second threshold. In this case, the positive power terminal 800 is in poor contact with the positive conducting wire 90. In other words, the control unit 81 is configured to: in response to the first temperature being greater than or equal to the second threshold, determine that the positive power terminal 800 is in poor contact with the positive conducting wire 90; and in response to the first temperature being less than the second threshold, determine that the positive power terminal 800 is in good contact with the positive conducting wire 90.

The control unit 81 is configured to determine whether the connection status between the negative power terminal 801 and the negative conducting wire 91 is the abnormal state, where the abnormal state includes that the second temperature is greater than or equal to a third threshold. In this case, the negative power terminal 801 is in poor contact with the negative conducting wire 91. In other words, the control unit 81 is configured to: in response to the second temperature being greater than or equal to the third threshold, determine that the negative power terminal 801 is in poor contact with the negative conducting wire 91; and in response to the second temperature being less than the third threshold, determine that the negative power terminal 801 is in good contact with the negative conducting wire 91. The second threshold may be equal or unequal to the third threshold. This is not limited in this application.

Through implementation of this embodiment of this application, because a local temperature near the first connection position c rises when the positive power terminal 800 is in poor contact with the positive conducting wire 90, and a local temperature near the second connection position d rises when the negative power terminal 801 is in poor contact with the negative conducting wire 91, abnormality detection on a positive pole side and abnormality detection on a negative pole side may be respectively performed based on the first temperature and the second temperature. Abnormality detection accuracy is higher, and a detection manner is more flexible and comprehensive.

In some feasible implementations, as shown in FIG. 15, the power distribution connector 80 shown in FIG. 13 further includes a positive conductor 804, a negative conductor 805, and a switch 806. For a connection relationship between the positive conductor 804, the negative conductor 805, and the switch 806 and another component, refer to the embodiment corresponding to FIG. 14. Details are not described herein again. After the connection status of the power distribution connector 80 is the abnormal state, a temperature at at least one of the first connection position c and the second connection position d further continuously rises. The control unit 51 is configured to: in response to either of the first temperature and the second temperature being greater than or equal to a second preset temperature threshold, control the switch 806 to be turned off. In this way, further rising of the temperature at the first connection position c and the temperature at the second connection position d can be avoided, so that security is improved. The second preset temperature threshold is greater than either of the second threshold and the third threshold.

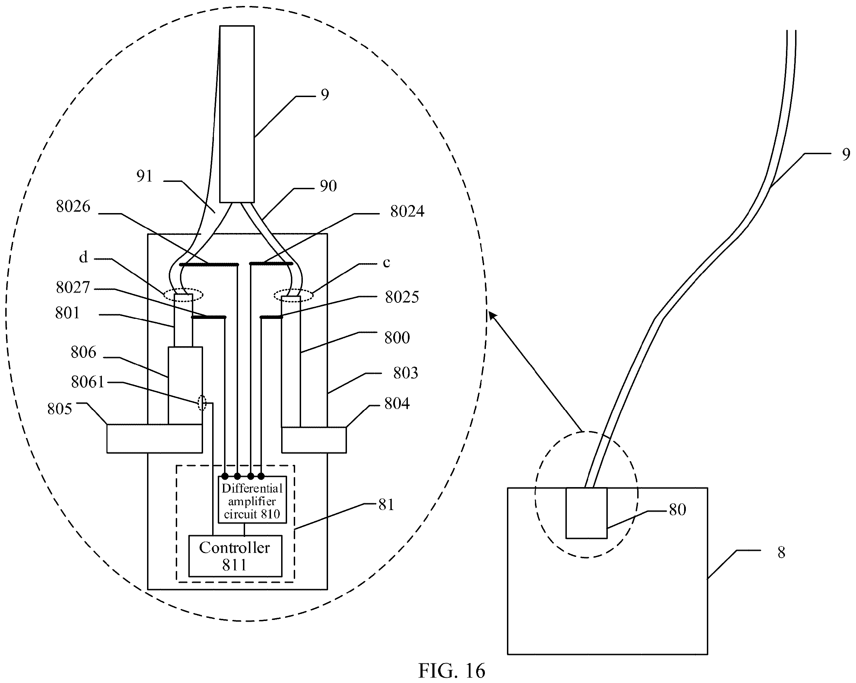

In some feasible implementations, as shown in FIG. 16, the sampling unit 802 shown in FIG. 13 includes a first positive probe 8024, a second positive probe 8025, a first negative probe 8026, and a second negative probe 8027. The control unit 81 includes a differential amplifier circuit 810 and a controller 811. For example, the controller 811 may be a processing chip inside the power distribution equipment 8. The differential amplifier circuit 810 and the controller 811 may be separately disposed. In this case, the differential amplifier circuit 810 may be disposed inside or outside the control unit 81. When the differential amplifier circuit 810 is disposed outside the control unit 81, the controller 811 is the control unit 81. Optionally, the differential amplifier circuit 810 may alternatively be integrated inside the controller 811. A specific position of the differential amplifier circuit 810 is not limited herein.

A first end of the first positive probe 8024 is connected to the positive conducting wire 90, and a second end of the first positive probe 8024 is connected to a first positive input end of the differential amplifier circuit 810. For example, the second end of the first positive probe 8024 is connected to the first positive input end of the differential amplifier circuit 810 through a signal line. A first end of the second positive probe 8025 is connected to a second end of the positive power terminal 800, and a second end of the second positive probe 8025 is connected to a second positive input end 810 of the differential amplifier circuit. For example, the second end of the second positive probe 8025 is connected to the second positive input end 810 of the differential amplifier circuit through a signal line.

A first end of the first negative probe 8026 is connected to the negative conducting wire 91, and a second end of the first negative probe 8026 is connected to a first negative input end of the differential amplifier circuit 810. For example, the second end of the first negative probe 8026 is connected to the first negative input end of the differential amplifier circuit 810 through a signal line. A first end of the second negative probe 8027 is connected to a second end of the negative power terminal 801, and a second end of the second negative probe 8027 is connected to a second negative input end of the differential amplifier circuit 810. For example, the second end of the second negative probe 8027 is connected to the second negative input end of the differential amplifier circuit 810 through a signal line. An output end of the differential amplifier circuit 810 is connected to the controller 811 through a signal line.

As shown in FIG. 13, a connector shell 803 is further included. The positive power terminal 800, the negative power terminal 801, the first positive probe 8024, the second positive probe 8025, the first negative probe 8026, and the second negative probe 8027 are all disposed inside the connector shell 803.

The following describes a manner that is of abnormality detection on a positive pole side and that corresponds to FIG. 15.

The first positive probe 8024 is configured to: detect a first positive voltage of the positive conducting wire 90, and output the first positive voltage to the differential amplifier circuit 810. The second positive probe 8025 is configured to: detect a second positive voltage of the positive power terminal 800, and output the second positive voltage to the differential amplifier circuit 810. In this case, the operating parameter of the power distribution connector 80 includes the first positive voltage and the second positive voltage.

Further, the differential amplifier circuit 810 is configured to: amplify a voltage difference between the first positive voltage and the second positive voltage to obtain an amplified positive voltage drop at a first connection position c, and output the amplified positive voltage drop to the controller 811. The voltage difference between the first positive voltage and the second positive voltage is a positive voltage drop at the first connection position c.

Still further, the controller 811 is configured to determine whether the connection status between the positive power terminal 800 and the positive conducting wire 90 is the abnormal state, where the abnormal state includes that the amplified positive voltage drop is greater than or equal to a fourth threshold. In this case, the positive power terminal 800 is in poor contact with the positive conducting wire 90. In other words, the controller 811 is configured to: in response to the amplified positive voltage drop being greater than or equal to the fourth threshold, determine that the positive power terminal 800 is in poor contact with the positive conducting wire 90; and in response to the amplified positive voltage drop being less than the fourth threshold, determine that the positive power terminal 800 is in good contact with the positive conducting wire 90.

Through implementation of this embodiment of this application, because the positive voltage drop at the first connection position c increases but by a small value when the positive power terminal 800 is in poor contact with the positive conducting wire 90, the differential amplifier circuit 810 can better detect a change process of the positive voltage drop after amplifying the positive voltage drop. In addition, there is no need to wait for a heat accumulation process at the first connection position c, to quickly identify whether the connection status between the positive power terminal 800 and the positive conducting wire 90 is the abnormal state, so that accuracy and a speed of the abnormality detection on the positive pole side can be improved, and security is higher.

The following describes a manner that is of abnormality detection on a negative pole side and that corresponds to FIG. 15.

The first negative probe 8026 is configured to: detect a first negative voltage of the negative conducting wire 91, and output the first negative voltage to the differential amplifier circuit 810. The second negative probe 8027 is configured to: detect a second negative voltage of the negative power terminal 801, and output the second negative voltage to the differential amplifier circuit 810. In this case, the operating parameter of the power distribution connector 80 further includes the first negative voltage and the second negative voltage. The connection status of the power distribution connector 80 further includes the connection status between the negative power terminal 801 and the negative conducting wire 91.

Further, the differential amplifier circuit 810 is configured to: amplify a voltage difference between the first negative voltage and the second negative voltage to obtain an amplified negative voltage drop at a second connection position d, and output the amplified negative voltage drop to the controller 811. The voltage difference between the first negative voltage and the second negative voltage is a negative voltage drop at the second connection position d.

Still further, the controller 811 is configured to determine whether the connection status between the negative power terminal 801 and the negative conducting wire 91 is the abnormal state, where the abnormal state includes that the amplified negative voltage drop is greater than or equal to a sixth threshold. In this case, the negative power terminal 801 is in poor contact with the negative conducting wire 91. In other words, the controller 811 is configured to: in response to the amplified negative voltage drop being greater than or equal to the sixth threshold, determine that the negative power terminal 801 is in poor contact with the negative conducting wire 91; and in response to the amplified negative voltage drop being less than the sixth threshold, determine that the negative power terminal 801 is in good contact with the negative conducting wire 91.

Through implementation of this embodiment of this application, because the negative voltage drop at the second connection position d increases but by a small value when the negative power terminal 801 is in poor contact with the negative conducting wire 91, the differential amplifier circuit 810 can better detect a change process of the negative voltage drop after amplifying the negative voltage drop. In addition, there is no need to wait for a heat accumulation process at the second connection position d, to quickly identify whether the connection status between the negative power terminal 801 and the negative conducting wire 91 is the abnormal state, so that accuracy and a speed of the abnormality detection on the negative pole side can be improved, and the security is higher. In addition, both the abnormality detection on the positive pole side and the abnormality detection on the negative pole side can be considered, and a detection manner is more flexible and comprehensive.

Optionally, in some feasible implementations, when the controller 811 may directly detect the change processes of the positive voltage drop and the negative voltage drop, the differential amplifier circuit 810 may alternatively not be disposed inside the control unit 81. In this case, the controller 811 may compare the positive voltage drop with a preset positive voltage drop threshold, to determine whether the connection status between the positive power terminal 800 and the positive conducting wire 90 is the abnormal state; and compare the negative voltage drop with a preset negative voltage drop threshold, to determine whether the connection status between the negative power terminal 801 and the negative conducting wire 91 is the abnormal state. For specific implementation, refer to the manners that are of the abnormality detection on the positive pole side and the negative pole side and that correspond to FIG. 15. Details are not described herein again. The preset positive voltage drop threshold is less than the fourth threshold, and the preset negative voltage drop threshold is less than the sixth threshold.

In some feasible implementations, as shown in FIG. 16, the power distribution connector 80 shown in FIG. 13 further includes a positive conductor 804, a negative conductor 805, and a switch 806. For a connection relationship between the positive conductor 804, the negative conductor 805, and the switch 806 and another component in the power distribution connector 80, refer to the embodiment corresponding to FIG. 14. Details are not described herein again. After the connection status of the power distribution connector 80 is the abnormal state, a voltage drop at at least one of the first connection position c and the second connection position d further continuously increases. In this case, the controller 811 is configured to: in response to any one of the amplified positive voltage drop and the positive voltage drop at the first connection position c and the amplified negative voltage drop and the negative voltage drop at the second connection position d being greater than or equal to a first preset voltage drop threshold, control the switch 806 to be turned off. In this case, no current flows through the power distribution connector 80. In this way, further increasing of the voltage drop at the first connection position c and the voltage drop at the second connection position d can be avoided, and the reliability of the power distribution connector 80 is higher. The first preset voltage drop threshold is greater than any one of the fourth threshold, the preset positive voltage drop threshold, the sixth threshold, and the preset negative voltage drop threshold.

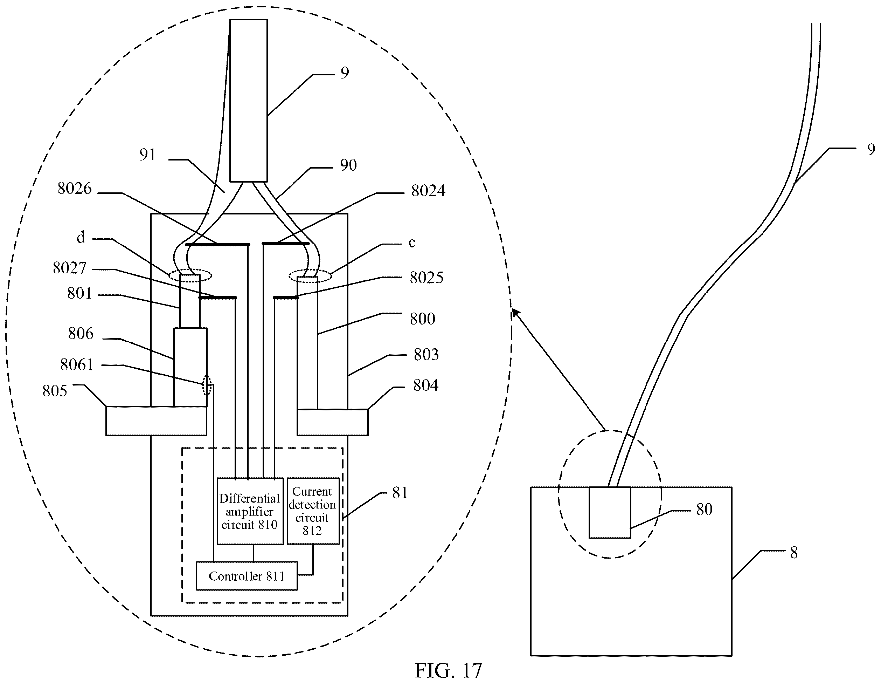

In some feasible implementations, as shown in FIG. 17, the control unit 81 shown in FIG. 16 further includes a current detection circuit 812, where the current detection circuit 812 and the controller 811 may be separately disposed. In this case, the current detection circuit 812 may alternatively be disposed outside the control unit 81. Optionally, the current detection circuit 812 may alternatively be integrated inside the controller 811. A specific position of the current detection circuit 812 is not limited herein.

The following describes a manner that is of abnormality detection on a positive pole side and that corresponds to FIG. 17.

The current detection circuit 812 is configured to: detect a current of the positive power terminal 800, and output the current of the positive power terminal 800 to the controller 811, where the current of the positive power terminal 800 is the same as a current at the first connection position c.

Further, the controller 811 is configured to: obtain amplified positive impedance at the first connection position based on the amplified positive voltage drop and the current of the positive power terminal 800, and determine whether the connection status between the positive power terminal 800 and the positive conducting wire 90 is the abnormal state, where the abnormal state includes that the amplified positive impedance is greater than or equal to a fifth threshold. In this case, the positive power terminal 800 is in poor contact with the positive conducting wire 90. In other words, the controller 811 is configured to: in response to the amplified positive impedance being greater than or equal to the fifth threshold, determine that the positive power terminal 800 is in poor contact with the positive conducting wire 90; and in response to the amplified positive impedance being less than the fifth threshold, determine that the positive power terminal 800 is in good contact with the positive conducting wire 90.

Through implementation of this embodiment of this application, because positive impedance at the first connection position c increases but by a small value when the positive power terminal 800 is in poor contact with the positive conducting wire 90, a change process of the positive impedance can be better detected after the amplified positive impedance is obtained based on the amplified positive voltage drop and the current of the positive power terminal 800. In addition, there is no need to wait for the heat accumulation process at the first connection position c, to quickly identify whether the connection status between the positive power terminal 800 and the positive conducting wire 90 is the abnormal state, so that accuracy and a speed of the abnormality detection on the positive pole side is improved.

The following describes a manner that is of abnormality detection on a negative pole side and that corresponds to FIG. 17.

The current detection circuit 812 is configured to: detect a current of the negative power terminal 801, and output the current of the negative power terminal 801 to the controller, where the current of the negative power terminal 801 is the same as a current at the second connection position d.

Further, the controller 811 is configured to: obtain amplified negative impedance at the second connection position d based on the amplified negative voltage drop and the current of the negative power terminal 801, and determine whether the connection status between the negative power terminal 801 and the negative conducting wire 91 is the abnormal state, where the abnormal state includes that the amplified negative impedance is greater than or equal to a seventh threshold. In this case, the negative power terminal 801 is in poor contact with the negative conducting wire 91. In other words, the controller 811 is configured to: in response to the amplified negative impedance being greater than or equal to the seventh threshold, determine that the negative power terminal 801 is in poor contact with the negative conducting wire 91; and in response to the amplified negative impedance being less than the seventh threshold, determine that the negative power terminal 801 is in good contact with the negative conducting wire 91.

Through implementation of this embodiment of this application, because negative impedance at the second connection position d increases but by a small value when the negative power terminal 801 is in poor contact with the negative conducting wire 91, a change process of the negative impedance can be better detected after the amplified negative impedance is obtained based on the amplified negative voltage drop and the current of the negative power terminal 801. In addition, there is no need to wait for the heat accumulation process at the second connection position d, to quickly identify whether the connection status between the negative power terminal 801 and the negative conducting wire 91 is the abnormal state, so that accuracy and a speed of the abnormality detection on the negative pole side can be improved. In addition, both the abnormality detection on the positive pole side and the abnormality detection on the negative pole side can be considered, and a detection manner is more flexible and comprehensive.

Optionally, in some feasible implementations, when the controller 811 may directly detect the change processes of the positive voltage drop and the negative voltage drop, the differential amplifier circuit 810 may alternatively not be disposed inside the control unit 81. In this case, the controller 811 is configured to: obtain the positive impedance at the first connection position c based on the positive voltage drop and the current of the positive power terminal 800, and compare the positive impedance with a preset positive impedance threshold, to determine whether the connection status between the positive power terminal 800 and the positive conducting wire 90 is the abnormal state. For specific implementation, refer to the manner that is of the abnormality detection on the positive pole side and that corresponds to FIG. 17. Details are not described herein again. The preset positive impedance threshold is less than the fifth threshold. The controller 811 is further configured to: obtain the negative impedance at the second connection position d based on the negative voltage drop and the current of the negative power terminal 801, and compare the negative impedance with a preset negative impedance threshold, to determine whether the connection status between the negative power terminal 801 and the negative conducting wire 91 is the abnormal state. For specific implementation, refer to the manner that is of the abnormality detection on the negative pole side and that corresponds to FIG. 17. Details are not described herein again. The preset negative impedance threshold is less than the seventh threshold.

In some feasible implementations, after the connection status of the power distribution connector 80 is the abnormal state, impedance at at least one of the first connection position c and the second connection position d further continuously increases. In this case, the controller 811 is configured to: in response to any one of the amplified positive impedance and the positive impedance at the first connection position c and the amplified negative impedance and the negative impedance at the second connection position d being greater than or equal to a first preset impedance threshold, control the switch 806 to be turned off. In this way, further increasing of the impedance at the first connection position c and the impedance at the second connection position d can be avoided, and the reliability of the power distribution connector 80 is higher. The first preset impedance threshold is greater than any one of the fourth threshold, the preset positive impedance threshold, the sixth threshold, and the preset negative impedance threshold.

In some feasible implementations, the control unit 81 or the controller 811 is configured to output alarm information to a user interface in response to the connection status of the power distribution connector 80 being the abnormal state, to indicate operations and maintenance personnel to repair the power distribution connector 80, so that the reliability of the power distribution connector 80 is further improved. The alarm information includes at least one abnormal operating parameter in a temperature at any position between the first connection position c and the second connection position d, a first temperature, a second temperature, the amplified positive voltage drop or the positive voltage drop, the amplified negative voltage drop or the negative voltage drop, the amplified positive impedance or the positive impedance, or the amplified negative impedance or the negative impedance. This is not limited herein.

In the embodiments corresponding to FIG. 13 to FIG. 17, any one of the first threshold, the second threshold, the third threshold, the fourth threshold, the fifth threshold, the sixth threshold, the seventh threshold, the first preset temperature threshold, the second preset temperature threshold, the preset positive voltage drop threshold, the preset negative voltage drop threshold, the first preset voltage drop threshold, the preset positive impedance threshold, the preset negative impedance threshold, and the first preset impedance threshold may be a preset value, or a value determined based on a component used in the power distribution connector 80.

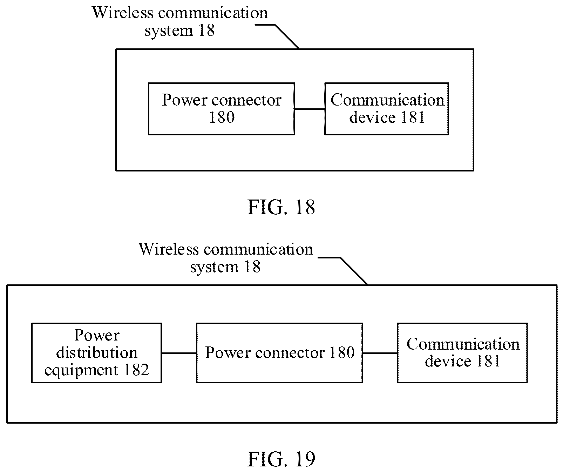

With reference to FIG. 18 and FIG. 19, the following describes, by using examples, a wireless communication system provided in embodiments of this application and an operating principle of the wireless communication system.

FIG. 18 is a block diagram of a structure of a wireless communication system according to an embodiment of this application. As shown in FIG. 18, the wireless communication system 18 includes a power connector 180 and a communication device 181. For example, the power connector 180 may be the power connector 2 shown in FIG. 2 to FIG. 6, and the communication device 181 may be the communication device 5 shown in FIG. 7 to FIG. 12. The power connector 180 is configured to receive electric energy provided by an external power supply, to supply power to the communication device 181. The external power supply may be a distribution box or a power distribution frame. It may be understood that, the communication device 181 may identify in advance whether a connection status of the power connector 180 is an abnormal state, so that reliability of the power connector 180 is improved. In this way, heat-induced carbonization of the power connector 180 or even burnout of the communication device 181 can be avoided, so that security of the wireless communication system 18 is improved.

In some feasible implementations, as shown in FIG. 19, the wireless communication system 18 shown in FIG. 18 further includes power distribution equipment 182. For example, the power distribution equipment 182 may be the power distribution equipment 8 shown in FIG. 13 to FIG. 17. For example, the power distribution equipment 182 may be a distribution box or a power distribution frame. The power distribution equipment 182 is configured to supply power to the communication device 181 through the power connector 180. It may be understood that, the power distribution equipment 182 may identify in advance whether a connection status of an internal power distribution connector is an abnormal state. In this way, heat-induced carbonization of the power distribution connector or even burnout of the power distribution equipment 182 can be avoided. In this case, abnormality detection of both the power distribution connector and the power connector 180 can be considered, and the security of the wireless communication system 18 is further improved. Optionally, the power connector 180 and the communication device 181 shown in FIG. 19 may alternatively be a common power connector and a common communication device. That is, in this case, a sampling unit and a male signal terminal may not be newly added to the power connector 180, and a female signal terminal may not be newly added to the communication device 181. This is not specifically limited herein.

It should be noted that the terms "first" and "second" are merely intended for a purpose of description, and cannot be understood as an indication or implication of relative importance.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A power connector, wherein the power connector comprises a positive power terminal, a negative power terminal, a male signal terminal, and a sampling unit, wherein a first end of the positive power terminal is configured to connect to a positive conducting wire in a power cable, a first end of the negative power terminal is configured to connect to a negative conducting wire in the power cable, the sampling unit is connected to a first end of the male signal terminal, and a second end of the male signal terminal is configured to connect to a female signal terminal in a device connector;
the sampling unit is configured to: detect an operating parameter of the power connector, and output the operating parameter to the male signal terminal; and
the male signal terminal is configured to output the operating parameter to the female signal terminal, wherein
the operating parameter is for determining whether a connection status of the power connector is an abnormal state.

2. The power connector according to claim 1, wherein the sampling unit comprises a temperature detection element, the temperature detection element is disposed between a first connection position and a second connection position, the first connection position is a connection position between the positive power terminal and the positive conducting wire, and the second connection position is a connection position between the negative power terminal and the negative conducting wire;
the operating parameter is a temperature at a position of the temperature detection element; and
when the temperature at the position of the temperature detection element is greater than or equal to a first threshold, the connection status of the power connector is the abnormal state.

3. The power connector according to claim 1, wherein the sampling unit comprises a first temperature detection element and a second temperature detection element, the first temperature detection element is disposed on a side that is of a first connection position and that faces away from a second connection position, the second temperature detection element is disposed on a side that is of the second connection position and that faces away from the first connection position, the first connection position is a connection position between the positive power terminal and the positive conducting wire, and the second connection position is a connection position between the negative power terminal and the negative conducting wire; and
the male signal terminal comprises a male positive signal terminal and a male negative signal terminal, and the female signal terminal comprises a female positive signal terminal and a female negative signal terminal; and the first temperature detection element is connected to a first end of the male positive signal terminal, a second end of the male positive signal terminal is configured to connect to the female positive signal terminal, the second temperature detection element is connected to a first end of the male negative signal terminal, and a second end of the male negative signal terminal is configured to connect to the female negative signal terminal.

4. The power connector according to claim 3, wherein the operating parameter comprises a first temperature at a position of the first temperature detection element and a second temperature at a position of the second temperature detection element, and the connection status of the power connector comprises at least one of a connection status between the positive power terminal and the positive conducting wire and a connection status between the negative power terminal and the negative conducting wire;
the first temperature detection element is configured to: detect the first temperature, and output the first temperature through the male positive signal terminal;
the second temperature detection element is configured to: detect the second temperature, and output the second temperature through the male negative signal terminal; and
when the first temperature is greater than or equal to a second threshold, the connection status between the positive power terminal and the positive conducting wire is an abnormal state; or when the second temperature is greater than or equal to a third threshold, the connection status between the negative power terminal and the negative conducting wire is an abnormal state.

5. The power connector according to claim 1, wherein the sampling unit comprises a first positive probe, a second positive probe, a first negative probe, and a second negative probe, the male signal terminal comprises a first male positive signal terminal, a second male positive signal terminal, a first male negative signal terminal, and a second male negative signal terminal, and the female signal terminal comprises a first female positive signal terminal, a second female positive signal terminal, a first female negative signal terminal, and a second female negative signal terminal;
the first positive probe is disposed between the positive conducting wire and a first end of the first male positive signal terminal, a second end of the first male positive signal terminal is configured to connect to the first female positive signal terminal, the second positive probe is disposed between a second end of the positive power terminal and a first end of the second male positive signal terminal, and a second end of the second male positive signal terminal is configured to connect to the second female positive signal terminal; and
the first negative probe is disposed between the negative conducting wire and a first end of the first male negative signal terminal, a second end of the first male negative signal terminal is configured to connect to the first female negative signal terminal, the second negative probe is disposed between a second end of the negative power terminal and a first end of the second male negative signal terminal, and a second end of the second male negative signal terminal is configured to connect to the second female negative signal terminal.

6. The power connector according to claim 5, wherein the operating parameter comprises a first positive voltage of the positive conducting wire and a second positive voltage of the positive power terminal, and the connection status of the power connector comprises a connection status between the positive power terminal and the positive conducting wire;
the first positive probe is configured to: detect the first positive voltage, and output the first positive voltage through the first male positive signal terminal; and
the second positive probe is configured to: detect the second positive voltage, and output the second positive voltage through the second male positive signal terminal, wherein
the first positive voltage and the second positive voltage are for determining a positive voltage drop at a first connection position, and the first connection position is a connection position between the positive power terminal and the positive conducting wire; and when the positive voltage drop is greater than or equal to a fourth threshold, the connection status between the positive power terminal and the positive conducting wire is an abnormal state.

7. The power connector according to claim 5 or 6, wherein the operating parameter further comprises a first negative voltage of the negative conducting wire and a second negative voltage of the negative power terminal, and the connection status of the power connector further comprises a connection status between the negative power terminal and the negative conducting wire;
the first negative probe is configured to: detect the first negative voltage, and output the first negative voltage through the first male negative signal terminal; and
the second negative probe is configured to: detect the second negative voltage, and output the second negative voltage through the second male negative signal terminal, wherein
the first negative voltage and the second negative voltage are for determining a negative voltage drop at a second connection position, and the second connection position is a connection position between the negative power terminal and the negative conducting wire; and when the negative voltage drop is greater than or equal to a fifth threshold, the connection status between the negative power terminal and the negative conducting wire is an abnormal state.

8. The power connector according to any one of claims 1 to 7, wherein the power connector further comprises a switch, the male signal terminal comprises a male switch signal terminal, and the female signal terminal comprises a female switch signal terminal, wherein the switch is disposed between the first end of the positive power terminal and the positive conducting wire, or the switch is disposed between the first end of the negative power terminal and the negative conducting wire; and a control end of the switch is connected to a first end of the male switch signal terminal, and a second end of the male switch signal terminal is configured to connect to the female switch signal terminal; and
after the connection status of the power connector is the abnormal state, the male switch signal terminal is configured to receive a low-level signal from the female switch signal terminal, wherein the low-level signal is for controlling the switch to be turned off.

9. A communication device, wherein the communication device comprises a device connector and a control unit, wherein the device connector comprises a positive jack terminal, a negative jack terminal, and a female signal terminal, the positive jack terminal is configured for a positive power terminal in a power connector to be plugged into, and the negative jack terminal is configured for a negative power terminal in the power connector to be plugged into;
the female signal terminal is configured to: receive an operating parameter of the power connector from a male signal terminal of the power connector, and output the operating parameter to the control unit; and
the control unit is configured to determine, based on the operating parameter, whether a connection status of the power connector is an abnormal state.

10. The communication device according to claim 9, wherein the operating parameter is a temperature at any position between a first connection position and a second connection position, the first connection position is a connection position between the positive power terminal and a positive conducting wire in a power cable, and the second connection position is a connection position between the negative power terminal and a negative conducting wire in the power cable; and
the control unit is configured to determine whether the connection status of the power connector is the abnormal state, wherein the abnormal state comprises that the temperature at the any position is greater than or equal to a first threshold.

11. The communication device according to claim 9, wherein the female signal terminal comprises a female positive signal terminal and a female negative signal terminal, and the male signal terminal comprises a male positive signal terminal and a male negative signal terminal, wherein the female positive signal terminal is configured to connect to the male positive signal terminal, and the female negative signal terminal is configured to connect to the male negative signal terminal;
the operating parameter comprises a first temperature at any position on a side that is of a first connection position and that faces away from a second connection position, the first connection position is a connection position between the positive power terminal and a positive conducting wire in a power cable, and the second connection position is a connection position between the negative power terminal and a negative conducting wire in the power cable; and the connection status of the power connector comprises a connection status between the positive power terminal and the positive conducting wire;
the female positive signal terminal is configured to: receive the first temperature from the male positive signal terminal, and output the first temperature to the control unit; and
the control unit is configured to determine whether the connection status between the positive power terminal and the positive conducting wire is an abnormal state, wherein the abnormal state comprises that the first temperature is greater than or equal to a second threshold.

12. The communication device according to claim 11, wherein the operating parameter further comprises a second temperature at any position on a side that is of the second connection position and that faces away from the first connection position, and the connection status of the power connector further comprises a connection status between the negative power terminal and the negative conducting wire;
the female negative signal terminal is configured to: receive the second temperature from the male negative signal terminal, and output the second temperature to the control unit; and
the control unit is configured to determine whether the connection status between the negative power terminal and the negative conducting wire is an abnormal state, wherein the abnormal state comprises that the second temperature is greater than or equal to a third threshold.

13. The communication device according to claim 9, wherein the female signal terminal comprises a first female positive signal terminal, a second female positive signal terminal, a first female negative signal terminal, and a second female negative signal terminal, the male signal terminal comprises a first male positive signal terminal, a second male positive signal terminal, a first male negative signal terminal, and a second male negative signal terminal, and the control unit comprises a differential amplifier circuit;
a first end of the first female positive signal terminal is configured to connect to the first male positive signal terminal, a second end of the first female positive signal terminal is connected to a first positive input end of the differential amplifier circuit, a first end of the second female positive signal terminal is configured to connect to the second male positive signal terminal, and a second end of the second female positive signal terminal is connected to a second positive input end of the differential amplifier circuit; and
a first end of the first female negative signal terminal is configured to connect to the first male negative signal terminal, a second end of the first female negative signal terminal is connected to a first negative input end of the differential amplifier circuit, a first end of the second female negative signal terminal is configured to connect to the second male negative signal terminal, and a second end of the second female negative signal terminal is connected to a second negative input end of the differential amplifier circuit.

14. The communication device according to claim 13, wherein the operating parameter comprises a first positive voltage of a positive conducting wire in a power cable and a second positive voltage of the positive power terminal, the connection status of the power connector comprises a connection status between the positive power terminal and the positive conducting wire, and the control unit further comprises a controller;
the first female positive signal terminal is configured to: receive the first positive voltage from the first male positive signal terminal, and output the first positive voltage to the differential amplifier circuit;
the second female positive signal terminal is configured to: receive the second positive voltage from the second male positive signal terminal, and output the second positive voltage to the differential amplifier circuit;
the differential amplifier circuit is configured to: amplify a voltage difference between the first positive voltage and the second positive voltage to obtain an amplified positive voltage drop at a first connection position, and output the amplified positive voltage drop to the controller, wherein the first connection position is a connection position between the positive power terminal and the positive conducting wire; and
the controller is configured to determine whether the connection status between the positive power terminal and the positive conducting wire is an abnormal state, wherein the abnormal state comprises that the amplified positive voltage drop is greater than or equal to a fourth threshold.

15. The communication device according to claim 14, wherein the control unit further comprises a current detection circuit;
the current detection circuit is configured to: detect a current of the positive jack terminal, and output the current of the positive jack terminal to the controller; and
the controller is configured to: obtain amplified positive impedance at the first connection position based on the amplified positive voltage drop and the current of the positive jack terminal, and determine whether the connection status between the positive power terminal and the positive conducting wire is an abnormal state, wherein the abnormal state comprises that the amplified positive impedance is greater than or equal to a fifth threshold.

16. The communication device according to any one of claims 13 to 15, wherein the operating parameter further comprises a first negative voltage of a negative conducting wire in the power cable and a second negative voltage of the negative power terminal, and the connection status of the power connector further comprises a connection status between the negative power terminal and the negative conducting wire;
the first female negative signal terminal is configured to: receive the first negative voltage from the first male negative signal terminal, and output the first negative voltage to the differential amplifier circuit;
the second female negative signal terminal is configured to: receive the second negative voltage from the second male negative signal terminal, and output the second negative voltage to the differential amplifier circuit;
the differential amplifier circuit is configured to: amplify a voltage difference between the first negative voltage and the second negative voltage to obtain an amplified negative voltage drop at a second connection position, and output the amplified negative voltage drop to the controller, wherein the second connection position is a connection position between the negative power terminal and the negative conducting wire; and
the controller is configured to determine whether the connection status between the negative power terminal and the negative conducting wire is an abnormal state, wherein the abnormal state comprises that the amplified negative voltage drop is greater than or equal to a sixth threshold.

17. The communication device according to claim 16, wherein the control unit further comprises the current detection circuit;
the current detection circuit is configured to: detect a current of the negative jack terminal, and output the current of the negative jack terminal to the controller; and
the controller is configured to: obtain amplified negative impedance at the second connection position based on the amplified negative voltage drop and the current of the negative jack terminal, and determine whether the connection status between the negative power terminal and the negative conducting wire is an abnormal state, wherein the abnormal state comprises that the amplified negative impedance is greater than or equal to a seventh threshold.

18. The communication device according to any one of claims 9 to 17, wherein the female signal terminal comprises a female switch signal terminal, and the male signal terminal comprises a male switch signal terminal, wherein the female switch signal terminal is configured to connect to the male switch signal terminal;
the control unit is configured to output a low-level signal to the female switch signal terminal after the connection status of the power connector is the abnormal state; and
the female switch signal terminal is configured to output the low-level signal to the male switch signal terminal, wherein
the low-level signal is for controlling a switch in the power connector to be turned off; and the switch is disposed between the positive power terminal and the positive conducting wire, or the switch is disposed between the negative power terminal and the negative conducting wire.

19. Power distribution equipment, wherein the power distribution equipment comprises a power distribution connector and a control unit, wherein the power distribution connector comprises a positive power terminal, a negative power terminal, and a sampling unit, a first end of the positive power terminal is configured to connect to a positive conducting wire in a power cable, and a first end of the negative power terminal is configured to connect to a negative conducting wire in the power cable;
the sampling unit is configured to: detect an operating parameter of the power distribution connector, and output the operating parameter to the control unit; and
the control unit is configured to determine, based on the operating parameter, whether a connection status of the power distribution connector is an abnormal state.

20. The power distribution equipment according to claim 19, wherein the sampling unit comprises a temperature detection element, the temperature detection element is disposed between a first connection position and a second connection position, the first connection position is a connection position between the positive power terminal and the positive conducting wire, the second connection position is a connection position between the negative power terminal and the negative conducting wire, and the operating parameter is a temperature at a position of the temperature detection element; and
the control unit is configured to determine whether the connection status of the power distribution connector is the abnormal state, wherein the abnormal state comprises that the temperature at the position of the temperature detection element is greater than or equal to a first threshold.

21. The power distribution equipment according to claim 19, wherein the sampling unit comprises a first temperature detection element and a second temperature detection element, the first temperature detection element is disposed on a side that is of a first connection position and that faces away from a second connection position, the second temperature detection element is disposed on a side that is of the second connection position and that faces away from the first connection position, the first connection position is a connection position between the positive power terminal and the positive conducting wire, and the second connection position is a connection position between the negative power terminal and the negative conducting wire;
the operating parameter comprises a first temperature at a position of the first temperature detection element and a second temperature at a position of the second temperature detection element, and the connection status of the power distribution connector comprises at least one of a connection status between the positive power terminal and the positive conducting wire and a connection status between the negative power terminal and the negative conducting wire;
the first temperature detection element is configured to: detect the first temperature, and output the first temperature to the control unit; and the second temperature detection element is configured to: detect the second temperature, and output the second temperature to the control unit; and
the control unit is configured to determine whether the connection status between the positive power terminal and the positive conducting wire is an abnormal state, wherein the abnormal state comprises that the first temperature is greater than or equal to a second threshold; and the control unit is configured to determine whether the connection status between the negative power terminal and the negative conducting wire is an abnormal state, wherein the abnormal state comprises that the second temperature is greater than or equal to a third threshold.

22. The power distribution equipment according to claim 19, wherein the sampling unit comprises a first positive probe, a second positive probe, a first negative probe, and a second negative probe, and the control unit comprises a differential amplifier circuit;
a first end of the first positive probe is connected to the positive conducting wire, a second end of the first positive probe is connected to a first positive input end of the differential amplifier circuit, a first end of the second positive probe is connected to a second end of the positive power terminal, and a second end of the second positive probe is connected to a second positive input end of the differential amplifier circuit; and
a first end of the first negative probe is connected to the negative conducting wire, a second end of the first negative probe is connected to a first negative input end of the differential amplifier circuit, a first end of the second negative probe is connected to a second end of the negative power terminal, and a second end of the second negative probe is connected to a second negative input end of the differential amplifier circuit.

23. The power distribution equipment according to claim 22, wherein the operating parameter comprises a first positive voltage of the positive conducting wire and a second positive voltage of the positive power terminal, the connection status of the power distribution connector comprises a connection status between the positive power terminal and the positive conducting wire, and the control unit further comprises a controller;
the first positive probe is configured to: detect the first positive voltage, and output the first positive voltage to the differential amplifier circuit; and the second positive probe is configured to: detect the second positive voltage, and output the second positive voltage to the differential amplifier circuit;
the differential amplifier circuit is configured to: amplify a voltage difference between the first positive voltage and the second positive voltage to obtain an amplified positive voltage drop at a first connection position, and output the amplified positive voltage drop to the controller, wherein the first connection position is a connection position between the positive power terminal and the positive conducting wire; and
the controller is configured to determine whether the connection status between the positive power terminal and the positive conducting wire is an abnormal state, wherein the abnormal state comprises that the amplified positive voltage drop is greater than or equal to a fourth threshold.

24. The power distribution equipment according to claim 23, wherein the control unit further comprises a current detection circuit;
the current detection circuit is configured to: detect a current of the positive power terminal, and output the current of the positive power terminal to the controller; and
the controller is configured to: obtain amplified positive impedance at the first connection position based on the amplified positive voltage drop and the current of the positive power terminal, and determine whether the connection status between the positive power terminal and the positive conducting wire is an abnormal state, wherein the abnormal state comprises that the amplified positive impedance is greater than or equal to a fifth threshold.

25. The power distribution equipment according to any one of claims 22 to 24, wherein the operating parameter further comprises a first negative voltage of the negative conducting wire and a second negative voltage of the negative power terminal, the connection status of the power distribution connector further comprises a connection status between the negative power terminal and the negative conducting wire, and the control unit further comprises the controller;
the first negative probe is configured to: detect the first negative voltage, and output the first negative voltage to the differential amplifier circuit; and the second negative probe is configured to: detect the second negative voltage, and output the second negative voltage to the differential amplifier circuit;
the differential amplifier circuit is configured to: amplify a voltage difference between the first negative voltage and the second negative voltage to obtain an amplified negative voltage drop at a second connection position, and output the amplified negative voltage drop to the controller, wherein the second connection position is a connection position between the negative power terminal and the negative conducting wire; and
the controller is configured to determine whether the connection status between the negative power terminal and the negative conducting wire is an abnormal state, wherein the abnormal state comprises that the amplified negative voltage drop is greater than or equal to a sixth threshold.

26. The power distribution equipment according to claim 25, wherein the control unit further comprises the current detection circuit;
the current detection circuit is configured to: detect a current of the negative power terminal, and output the current of the negative power terminal to the controller; and
the controller is configured to: obtain amplified negative impedance at the second connection position based on the amplified negative voltage drop and the current of the negative power terminal, and determine whether the connection status between the negative power terminal and the negative conducting wire is an abnormal state, wherein the abnormal state comprises that the amplified negative impedance is greater than or equal to a seventh threshold.

27. The power distribution equipment according to any one of claims 19 to 26, wherein the power distribution connector further comprises a positive conductor, a negative conductor, and a switch; a third end of the positive power terminal is connected to a first end of the positive conductor, a second end of the positive conductor is configured to connect to a positive pole of an external power supply, a third end of the negative power terminal is connected to a first end of the negative conductor, and a second end of the negative conductor is configured to connect to a negative pole of the external power supply; and the switch is disposed between the third end of the positive power terminal and the first end of the positive conductor, or the switch is disposed between the third end of the negative power terminal and the first end of the negative conductor; and
the control unit is further configured to: after the connection status of the power distribution connector is the abnormal state, control the switch to be turned off.

28. A wireless communication system, wherein the wireless communication system comprises the power connector according to any one of claims 1 to 9 and the communication device according to any one of claims 10 to 18.

29. The wireless communication system according to claim 28, wherein the wireless communication system further comprises the power distribution equipment according to any one of claims 19 to 27, wherein
the power distribution equipment is configured to supply power to the communication device through the power connector.

30. A wireless communication system, wherein the wireless communication system comprises a communication device, a power connector, and the power distribution equipment according to any one of claims 19 to 27, wherein the power distribution equipment is configured to supply power to the communication device through the power connector.
